(19) Europäisches Patentamt
European Patent Office
Office européen des brevets

(11) EP 4 787 001 A1

(12) EUROPEAN PATENT APPLICATION
published in accordance with Art. 153(4) EPC

(43) Date of publication:
05.08.2026 Bulletin 2026/32

(21) Application number: 24871616.9

(22) Date of filing: 22.08.2024

(51) International Patent Classification (IPC):
G01R 33/10 (2006.01)      G01R 15/20 (2006.01)
G01R 19/00 (2006.01)      G01R 33/02 (2006.01)

(52) Cooperative Patent Classification (CPC):
G01R 15/20; G01R 19/00; G01R 33/02;
G01R 33/10

(86) International application number:
PCT/JP2024/029870

(87) International publication number:
WO 2025/069814 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.09.2023 JP 2023170115

(71) Applicant: CITIZEN FINEDEVICE CO., LTD.
Minamitsuru-gun, Yamanashi 401-0395 (JP)

(72) Inventors:
• MIYAMOTO, Mitsunori
Minamitsuru-gun, Yamanashi 401-0395 (JP)
• SUE, Satoshi
Minamitsuru-gun, Yamanashi 401-0395 (JP)

(74) Representative: Ricker, Mathias
Wallinger Ricker Schlotter Tostmann
Patent- und Rechtsanwälte Partnerschaft mbB
Zweibrückenstraße 5-7
80331 München (DE)

(54) CURRENT-DISTRIBUTION ESTIMATION DEVICE, CURRENT-DISTRIBUTION ESTIMATION METHOD, CURRENT-DISTRIBUTION ESTIMATION PROGRAM, AND CURRENT-DISTRIBUTION ESTIMATION SYSTEM

(57) A current distribution estimation device includes an acquisition unit that acquires magnetic field signals respectively indicating a plurality of magnetic fields detected at a plurality of detection positions on a surface of a conductor through which current flows; an optimization unit that optimizes, based on a predetermined optimization algorithm, current that generates magnetic fields detected at the plurality of detection positions, respectively; a calculation unit that calculates a plurality of magnetic fields generated at the plurality of detection positions by current optimized by the optimization unit; a determination unit that determines whether the plurality of magnetic fields acquired by the acquisition unit matches the plurality of magnetic fields calculated by the calculation unit; and an output unit that outputs a current signal indicating the current optimized by the optimization unit, when the determination unit determines that the plurality of magnetic fields acquired by the acquisition unit matches the plurality of magnetic fields calculated by the calculation unit.

Fig. 1

**Description**

FIELD

The present disclosure relates to a current distribution estimation device, a current distribution estimation method, a current distribution estimation program, and a current distribution estimation system.

BACKGROUND

In recent years, semiconductor materials forming switching elements used in power converters, such as inverters and converters, have been changed from Si semiconductors to SiC semiconductors and GaN semiconductors, which can withstand higher voltages, to improve the withstand voltage of the switching elements.
In addition, from the viewpoint of reducing inductance, leadless packages (surface mount type) are starting to be used, instead of conventional TO packages (e.g., TO-247), as switching elements used in power converters for downsizing the power converters. When a TO package is used as a switching element, current flowing through the switching element can be measured via the leads; however, in the case of a leadless package, measurement of current flowing through a switching element requires using a flat conductive pattern disposed on a circuit board. Current flowing through a flat conductive pattern disposed on a circuit board is not easily measured with a general ammeter, such as a Rogowski coil, a current probe, or a current transformer.
In flat conductors such as a flat conductive pattern disposed on a circuit board and a bus bar connecting devices, current may flow unevenly in the flat conductors without flowing uniformly. The design of a power converter having a flat conductor can be optimized by measuring the distribution of current flowing unevenly in the conductor. However, a general ammeter such as a Rogowski coil, which integrates a magnetic field around a conductor to measure current, cannot measure local current unevenness and current distribution in a flat conductor.
Japanese Patent No. 7222480 (hereafter "Patent Document 1") describes a magnetic field sensor device including a Faraday rotator formed of a granular film and capable of downsizing. By including a Faraday rotator capable of downsizing, the magnetic field sensor device described in Patent Document 1 can detect a magnetic field distribution near the surface of a flat conductor with high accuracy.

SUMMARY

Although the magnetic field sensor device described in Patent Document 1 can detect a magnetic field distribution on the surface of a flat conductor with high accuracy, the distribution of current flowing through a conductor is not easily estimated from a magnetic field distribution detected by the magnetic field sensor device described in Patent Document 1.
The present disclosure aims to solve such problems and to provide a current distribution estimation device that can estimate a current distribution of a flat conductor and a conductor in which current is unevenly distributed because of the skin effect and proximity effect.
A current distribution estimation device of the present disclosure includes an acquisition unit that acquires magnetic field signals respectively indicating a plurality of magnetic fields detected at a plurality of detection positions on a surface of a conductor through which current flows; an optimization unit that optimizes, based on a predetermined optimization algorithm, current that generates magnetic fields detected at the plurality of detection positions, respectively; a calculation unit that calculates a plurality of magnetic fields generated at the plurality of detection positions by current optimized by the optimization unit; a determination unit that determines whether the plurality of magnetic fields acquired by the acquisition unit matches the plurality of magnetic fields calculated by the calculation unit; and an output unit that outputs a current signal indicating the current optimized by the optimization unit, when the determination unit determines that the plurality of magnetic fields acquired by the acquisition unit matches the plurality of magnetic fields calculated by the calculation unit.
In the current distribution estimation device of the present invention, the calculation unit preferably determines an initial value of the current that generates magnetic fields detected at the plurality of detection positions, respectively, and the optimization unit preferably optimizes the initial value.
In the current distribution estimation device of the present invention, the calculation unit preferably calculates each of the plurality of magnetic fields by assuming that the current that generates magnetic fields detected at the plurality of detection positions, respectively, is a current flowing through a conductor with a circular cross section.
In the current distribution estimation device of the present invention, the optimization unit preferably optimizes the current, based on a genetic algorithm, a gradient descent method, or a local search method.
In the current distribution estimation device of the present invention, the optimization unit preferably optimizes the current, based on a gradient descent method.

In the current distribution estimation device of the present invention, the optimization unit preferably uses a least-squares method to calculate an error between the plurality of magnetic fields acquired by the acquisition unit and the plurality of magnetic fields calculated by the calculation unit.

A current distribution estimation method of the present invention includes acquiring magnetic field signals respectively indicating a plurality of magnetic fields detected at a plurality of detection positions on a surface of a conductor through which current flows; optimizing, based on a predetermined optimization algorithm, current that generates magnetic fields detected at the plurality of detection positions, respectively; calculating a plurality of magnetic fields generated at the plurality of detection positions by the optimized current; determining whether the acquired plurality of magnetic fields matches the calculated plurality of magnetic fields; and outputting a current signal indicating the optimized current, when it is determined that the acquired plurality of magnetic fields matches the calculated plurality of magnetic fields.

A current distribution estimation program of the present invention causes a computer to execute a process including acquiring magnetic field signals respectively indicating a plurality of magnetic fields detected at a plurality of detection positions on a surface of a conductor through which current flows; optimizing, based on a predetermined optimization algorithm, current that generates magnetic fields detected at the plurality of detection positions, respectively; calculating a plurality of magnetic fields generated at the plurality of detection positions by the optimized current; determining whether the acquired plurality of magnetic fields matches the calculated plurality of magnetic fields; and outputting a current signal indicating the optimized current, when it is determined that the acquired plurality of magnetic fields matches the calculated plurality of magnetic fields.

A current distribution estimation system of the present invention includes a magnetic field sensor device that detects a plurality of magnetic fields at a plurality of detection positions on a surface of a conductor through which current flows, and that outputs magnetic field signals respectively indicating the detected plurality of magnetic fields; and a current distribution estimation device that estimates a current distribution that generates magnetic fields corresponding to the magnetic field signals. The current distribution estimation device includes an acquisition unit that acquires the magnetic field signals; an optimization unit that optimizes, based on a predetermined optimization algorithm, current that generates magnetic fields detected at the plurality of detection positions, respectively; a calculation unit that calculates a plurality of magnetic fields generated at the plurality of detection positions by current optimized by the optimization unit; a determination unit that determines whether the plurality of magnetic fields acquired by the acquisition unit matches the plurality of magnetic fields calculated by the calculation unit; and an output unit that outputs a current signal indicating the current optimized by the optimization unit, when the determination unit determines that the plurality of magnetic fields acquired by the acquisition unit matches the plurality of magnetic fields calculated by the calculation unit.

The current distribution estimation device of the present invention can estimate a current distribution of a conductor and a conductor in which current is unevenly distributed because of the skin effect and proximity effect.

BRIEF DESCRIPTION OF DRAWINGS

FIG. 1(a) is a schematic diagram of a current distribution estimation system including a current distribution estimation device of a first embodiment; (b) is a cross-sectional view taken along line A-A shown in (a).

FIG. 2 is a block diagram of the first magnetic field sensor device shown in FIG. 1.

FIG. 3 is a block diagram of the second magnetic field sensor device shown in FIG. 1.

FIG. 4 is a block diagram of the current distribution estimation device shown in FIG. 1.

FIG. 5 is a flowchart of a current distribution estimation process executed by the current distribution estimation device shown in FIG. 4.

FIG. 6 is a flowchart showing the processing indicated by S108 in FIG. 5 in more detail.

FIG. 7(a) shows time-varying changes in current supplied to a conductor from the current source shown in FIG. 1; (b) shows the magnetic field distribution in the width direction of the conductor at the time indicated by arrow D in (a); (c) shows the result of current distribution estimation by the current distribution estimation device corresponding to (b).

FIG. 8 is a block diagram of a current distribution estimation device of a second embodiment.

FIG. 9 is a flowchart of a current distribution estimation process executed by the current distribution estimation device shown in FIG. 8.

FIG. 10 is a diagram for explaining a gradient descent process indicated by S308 in FIG. 9.

FIG. 11 shows the result (part 1) of current distribution estimation by the current distribution estimation device shown in FIG. 8; (a) shows the relationship between a target current and initial values of currents; (b) shows the relationship between magnetic fields corresponding to the initial values of currents and a target magnetic field; (c) shows the relationship between the target current and estimated values of currents; (d) shows the relationship between magnetic fields corresponding to the estimated values of currents and the target magnetic field.

FIG. 12 shows the result (part 2) of current distribution estimation by the current distribution estimation device shown in FIG. 8; (a) shows the relationship between a target current and initial values of currents; (b) shows the relationship between magnetic fields corresponding to the initial values of currents and a target magnetic field; (c) shows the relationship between the target current and estimated values of currents; (d) shows the relationship between magnetic fields corresponding to the estimated values of currents and the target magnetic field.

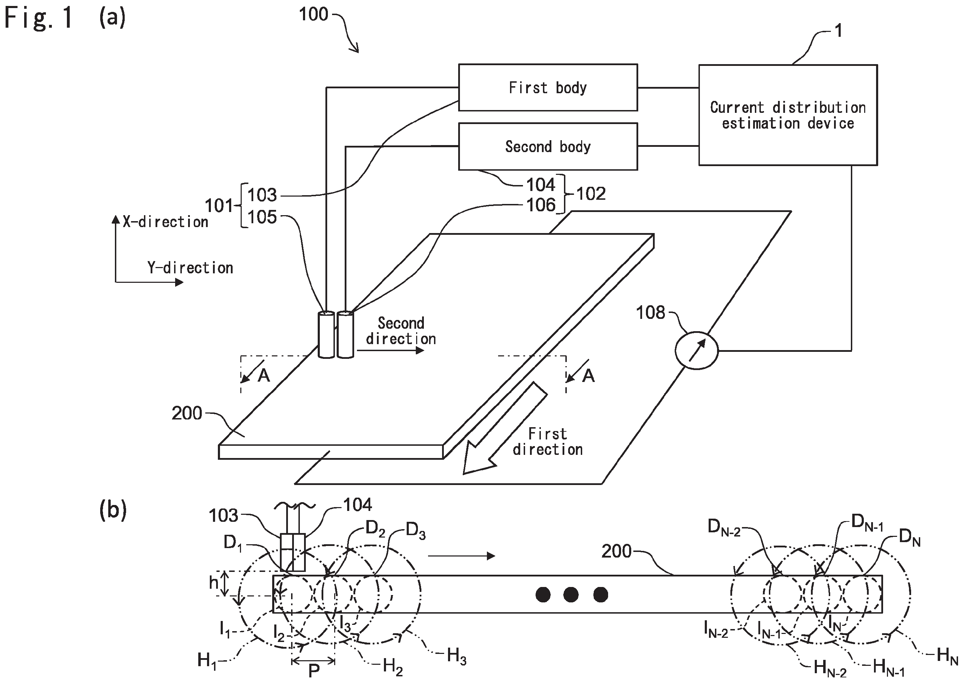

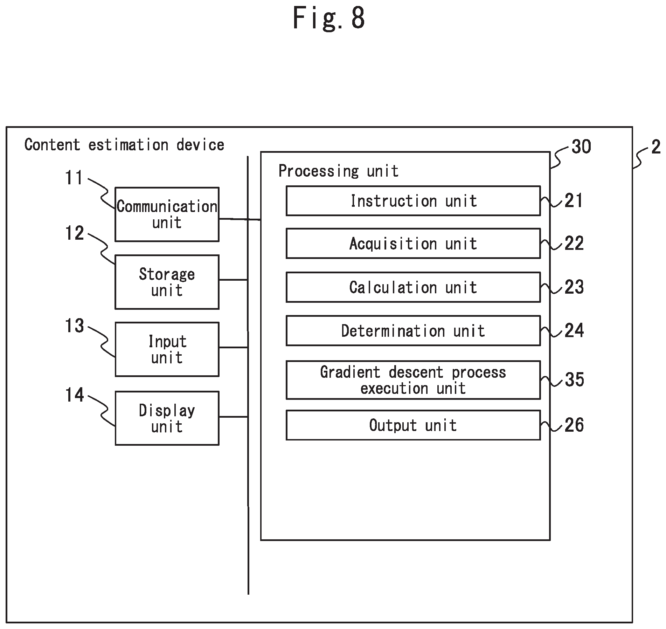

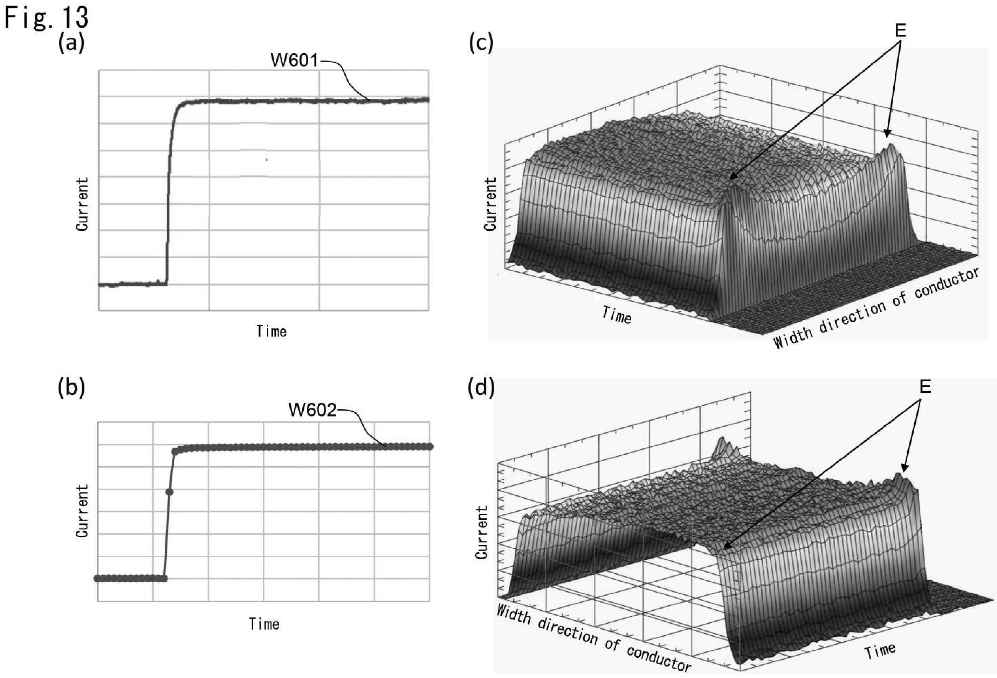

FIG. 13 shows the result (part 3) of current distribution estimation by the current distribution estimation device shown in FIG. 8; (a) shows time-varying changes in current supplied to a conductor from the current source shown in FIG. 1; (b) shows time-varying changes in estimated values of the current supplied to the conductor from the current source; (c) shows time-varying changes (part 1) in estimated values of the distribution of the current supplied to the conductor from the current source; (d) shows time-varying changes (part 2) in estimated values of the distribution of the current supplied to the conductor from the current source.

FIG. 14 is a flowchart of a current distribution estimation process of a modified example executed by the current distribution estimation device shown in FIG. 8.

FIG. 15(a) shows a conductor of a first modified example; (b) shows a conductor of a second modified example; (c) shows a conductor of a third modified example; (d) shows a conductor of a fourth modified example.

DESCRIPTION OF EMBODIMENTS

A current distribution estimation device, a current distribution estimation method, a current distribution estimation program, and a current distribution estimation system of an embodiment will now be described with reference to the drawings. However, note that the technical scope of the present invention is not limited to embodiments thereof and covers the invention set forth in the claims and equivalents thereof.

FIG. 1(a) is a schematic diagram of a current distribution estimation system including a current distribution estimation device of a first embodiment; FIG. 1(b) is a cross-sectional view taken along line A-A shown in FIG. 1(a).

A current distribution estimation system 100 includes a first magnetic field sensor device 101, a second magnetic field sensor device 102, a current source 108, and a current distribution estimation device 1, and estimates a current distribution when current supplied from the current source 108 flows through a flat conductor 200 in a first direction indicated by an arrow. Examples of the flat conductor 200 are a bus bar disposed on a power switchboard of a power receiving device and a conductive pattern that is a metal thin film disposed on a circuit board.

The first magnetic field sensor device 101 includes a first body 103 and a first sensor head 105, detects a magnetic field in an X-direction generated by current flowing through the conductor 200, i.e., a magnetic field in the direction normal to a surface of the conductor 200, and outputs a first magnetic field signal indicating the detected magnetic field to the current distribution estimation device 1. The second magnetic field sensor device 102 includes a second body 104 and a second sensor head 106, detects a magnetic field in a Y-direction generated by current flowing through the conductor 200, i.e., a magnetic field in a direction perpendicular to the X-direction, and outputs a second magnetic field signal indicating the detected magnetic field to the current distribution estimation device 1. The first magnetic field sensor device 101 and the second magnetic field sensor device 102 detect the distribution of a magnetic field generated by current flowing through the conductor 200, by the first sensor head 105 and the second sensor head 106 scanning in a second direction perpendicular to the first direction in which the current flows through the conductor 200. The second direction of scanning with the first sensor head 105 and the second sensor head 106 is parallel to the Y-direction in which the second sensor head 106 detects a magnetic field.

The first sensor head 105 and the second sensor head 106 may be supported by a moving mechanism (not shown) that can move the first sensor head 105 and the second sensor head 106 in the second direction. The moving mechanism (not shown) moves the first sensor head 105 and the second sensor head 106 along the second direction while keeping the first sensor head 105 and the second sensor head 106 at a position separated from the center of the conductor 200 by a height h in the direction normal to the surface of the conductor 200. The moving mechanism (not shown) sequentially moves the first sensor head 105 and the second sensor head 106 to N detection positions along the second direction from a first detection position $D_1$ to an N-th detection position $D_N$. The first detection position $D_1$ to the N-th detection position $D_N$ are separated from one another by a distance of a detection pitch P. The first sensor head 105 and the second sensor head 106 detect a first magnetic field $H_1$ to an N-th magnetic field $H_N$ generated by current flowing through the conductor 200 at the first detection position $D_1$ to the N-th detection position $D_N$, respectively.

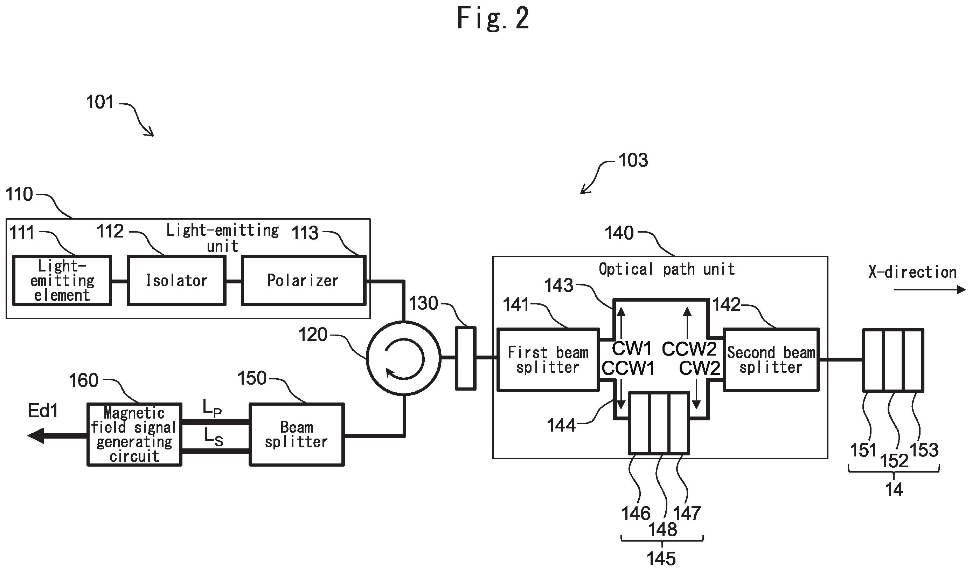

FIG. 2 is a block diagram of the first magnetic field sensor device 101.

The first magnetic field sensor device 101 includes a light-emitting unit 110, a circulator 120, a first optical element 130, an optical path unit 140, the first sensor head 105, a beam splitter 150, and a magnetic field signal generating circuit 160. The light-emitting unit 110, the circulator 120, the first optical element 130, the optical path unit 140, the beam splitter 150, and the magnetic field signal generating circuit 160 are housed in the first body 103. The optical paths between the light-emitting unit 110, the circulator 120, the first optical element 130, the optical path unit 140, the first sensor head 105, the beam splitter 150, and the magnetic field signal generating circuit 160 are formed of PANDA fibers. The optical paths between the light-emitting unit 110 and the magnetic field signal generating circuit 160 may be formed of polarization maintaining optical fibers, such as bow-tie fibers and elliptical jacket fibers.

The light-emitting unit 110 includes a light-emitting element 111, an isolator 112, and a polarizer 113. The light-emitting element 111 is, for example, a semiconductor laser or a light-emitting diode. Specifically, a Fabry-Perot laser, a superluminescent diode, or the like can be preferably used as the light-emitting element 111. The light-emitting unit 110 emits laser light in response to an instruction from an external device (not shown). The laser light emitted from the light-emitting unit 110 is outputted as an alternating-current waveform such as a sine waveform that oscillates every predetermined period.

The isolator 112 transmits light incident from the light-emitting element 111 toward the circulator 120, and does not transmit light incident from the circulator 120 toward the light-emitting element 111, thereby protecting the light-emitting element 111. The isolator 112 is, for example, a polarization-dependent optical isolator, but may be a polarization-independent optical isolator.

The polarizer 113 is an optical element for converting light emitted by the light-emitting element 111 into linearly polarized-wave light, and may be of any type. First linearly polarized-wave light having a sine waveform obtained by the polarizer 113 is incident on the first optical element 130 via the circulator 120. The first linearly polarized-wave light is also referred to as incident light.

The circulator 120 is an optical branching unit that transmits first linearly polarized-wave light emitted from the light-emitting unit 110 to the first optical element 130 and that makes second linearly polarized-wave light having a sine waveform emitted from the first optical element 130 branch off to the magnetic field signal generating circuit 160. The circulator 120 is formed of, for example, a Faraday rotator, a half-wave plate, a polarizing beam splitter, and multiple reflecting mirrors. The second linearly polarized-wave light is also referred to as return light.

The first optical element 130 is, for example, a half-wave plate disposed so that its azimuth angle is 22.5 degrees with respect to the plane of polarization of first linearly polarized-wave light incident from the circulator 120. The first optical element 130 rotates the plane of polarization of first linearly polarized-wave light incident from the circulator 120 by 45 degrees, and emits the first linearly polarized-wave light to the optical path unit 140. The first linearly polarized-wave light whose plane of polarization is rotated 45 degrees by the first optical element 130 includes first linearly polarized light CW1 that is P-polarized light and second linearly polarized light CCW1 that is S-polarized light perpendicular to the first linearly polarized light CW1.

The first optical element 130 also rotates the plane of polarization of second linearly polarized-wave light that is linearly polarized-wave light incident from the optical path unit 140 by 45 degrees, and emits the linearly polarized-wave light to the circulator 120.

The optical path unit 140 includes a first beam splitter 141, a second beam splitter 142, a first optical path 143, a second optical path 144, and a second optical element 145.

The first beam splitter 141 emits the first linearly polarized light CW1 to the first optical path 143, and also emits the second linearly polarized light CCW1 to the second optical path 144. On the first beam splitter 141, third linearly polarized light CW2 is incident from the second optical path 144, and fourth linearly polarized light CCW2 is incident from the first optical path 143. The third linearly polarized light CW2 and the fourth linearly polarized light CCW2 are polarized components of the second linearly polarized-wave light emitted to the first optical element 130 that are perpendicular to each other.

On the second beam splitter 142, the first linearly polarized light CW1 is incident from the first optical path 143, and the second linearly polarized light CCW1 is incident from the second optical path 144; the second beam splitter emits the incident first linearly polarized light CW1 and second linearly polarized light CCW1 to the first sensor head 105. In addition, the second beam splitter 142 emits the third linearly polarized light CW2 incident from the first sensor head 105 to the second optical path 144, and also emits the fourth linearly polarized light CCW2 incident from the first sensor head 105 to the first optical path 143.

The first beam splitter 141 and the second beam splitter 142 separate the first linearly polarized-wave light into a P-polarized component and an S-polarized component, and combine the P-polarized component and the S-polarized component to emit the combined light. The first beam splitter 141 and the second beam splitter 142 are, for example, prism-type beam splitters, but may be flat-type beam splitters or wedge-type beam splitters.

The first optical path 143 guides the first linearly polarized light CW1 introduced from the first beam splitter 141 to the second beam splitter 142, and also guides the fourth linearly polarized light CCW2 introduced from the second beam splitter 142 to the first beam splitter 141. The second optical path 144 guides the second linearly polarized light CCW1 introduced from the first beam splitter 141 to the second beam splitter 142, and also guides the third linearly polarized light CW2 introduced from the second beam splitter 142 to the first beam splitter 141.

The first optical path 143 is a PANDA fiber having one end optically connected to the first beam splitter 141 and the other end optically connected to the second beam splitter 142. The second optical path 144 is a PANDA fiber having one end optically connected to the first beam splitter 141 and the other end optically connected to the second beam splitter 142. The first optical path 143 and the second optical path 144 may be polarization maintaining fibers, such as bow-tie fibers and elliptical jacket fibers. In the second optical path 144 is disposed the second optical element 145.

The second optical element 145 includes a first quarter-wave plate 146, a second quarter-wave plate 147, and a 45-degree Faraday rotator 148.

The first quarter-wave plate 146 is a quarter-wave plate disposed with its optical axis inclined 45 degrees with respect to the slow axis and fast axis of the PANDA fiber forming the second optical path 144. The first quarter-wave plate 146 converts linearly polarized light into circularly polarized light, and also converts circularly polarized light into linearly polarized light.

The second quarter-wave plate 147 is a quarter-wave plate disposed with its optical axis inclined -45 degrees with respect to the slow axis and fast axis of the PANDA fiber forming the second optical path 144. The second quarter-wave plate 147 converts circularly polarized light from the 45-degree Faraday rotator 148 into linearly polarized light, and also converts linearly polarized light into circularly polarized light.

The 45-degree Faraday rotator 148 is a Faraday rotator that changes the phase of circularly polarized light incident from the first quarter-wave plate 146 and the second quarter-wave plate 147.

The 45-degree Faraday rotator 148 changes the phase of circularly polarized light incident from the first quarter-wave plate 146 so as to shift the phase of the second linearly polarized light CCW1 by 45 degrees. In addition, the 45-degree Faraday rotator 148 changes the phase of circularly polarized light so that the phase of the third linearly polarized light CW2 emitted from the first quarter-wave plate 146 is shifted -45 degrees from the phase of the third linearly polarized light CW2 incident on the second quarter-wave plate 147.

The first sensor head 105 includes a quarter-wave plate 151, a Faraday rotator 152, and a mirror element 153, is connected to the second beam splitter 142 via a PANDA fiber, and is an element at least part of which can be disposed within a predetermined magnetic field. The first sensor head 105 detects the X-component of a magnetic field generated by current flowing through the conductor 200. On the first sensor head 105, the first linearly polarized-wave light emitted by the light-emitting unit 110 is incident as incident light; the first sensor head emits return light depending on the incident light.

The quarter-wave plate 151 is disposed with its optical axis inclined 45 degrees with respect to the slow axis and fast axis of the PANDA fiber optically connecting the quarter-wave plate and the second beam splitter 142. The quarter-wave plate 151 changes the state of polarization of incident light, which is linearly polarized light, into circular polarization, and also changes the state of polarization of return light, which is incident as circularly polarized light from the Faraday rotator 152, into linear polarization.

The Faraday rotator 152 is a granular film including a dielectric and nano-order magnetic particles dispersed in the dielectric in a state of stable phase separation from the dielectric, and is disposed on the end face of the quarter-wave plate 151. The magnetic particles may form oxides in a small part, e.g., in the outermost layer; however, throughout the Faraday rotator 152, the magnetic particles are dispersed independently in the thin film without forming a compound with the dielectric serving as a binder. The distribution of the magnetic particles in the Faraday rotator 152 need not be completely uniform, and may be somewhat biased. If a highly transparent dielectric is used, the Faraday rotator 152 will have optical transparency because of the magnetic particles being present in the dielectric in a size smaller than the wavelength of light.

The Faraday rotator 152 may be a magnetic thin film other than a granular film. For example, the Faraday rotator 152 may be a single-crystal rare-earth iron garnet thin film having a garnet-type crystal structure represented by the composition formula $R_XY_{3-X}Fe_5O_{12}$ in which rare-earth iron garnet is substituted with Y. R is a rare-earth metal, and is an element that can be substituted for Y.

The Faraday rotator 152 is not limited to a single layer, and may be a multilayer film in which granular films and dielectric films are alternately laminated. If the Faraday rotator 152 is formed of a multilayer granular film, the Faraday rotation angle will be increased by multiple reflection within the granular film.

The dielectric is preferably a fluoride (metal fluoride) such as magnesium fluoride ($MgF_2$), aluminum fluoride

(AlF$_3$), or yttrium fluoride (YF$_3$). The dielectric 520 may be an oxide such as tantalum oxide (Ta$_2$O$_5$), silicon dioxide (SiO$_2$), titanium dioxide (TiO$_2$), niobium pentoxide (Nb$_2$O$_5$), zirconium dioxide (ZrO$_2$), hafnium dioxide (HfO$_2$), or aluminum trioxide (Al$_2$O$_3$). For good phase separation from the dielectric magnetic particles, fluorides are more preferable than oxides, and magnesium fluoride, which has high transmittance, is particularly preferable.

The magnetic particles only have to produce the Faraday effect and may be made of any material; examples of the material of the magnetic particles include iron (Fe), cobalt (Co), and nickel (Ni), which are ferromagnetic metals, and alloys thereof. Examples of alloys of Fe, Co, and Ni include FeNi alloys, FeCo alloys, FeNiCo alloys, and NiCo alloys. The Faraday rotation angle per unit length of Fe, Co, and Ni is two to three orders of magnitude greater than that of magnetic garnet applied to conventional Faraday rotators.

The mirror element 153 is formed on the Faraday rotator 152, and reflects light transmitted through the Faraday rotator 152 toward the Faraday rotator 152. As the mirror element 153 can be used, for example, a silver (Ag) film, a gold (Au) film, an aluminum (Al) film, a dielectric multilayer mirror, or the like. In particular, a Ag film having a high reflectance and a Au film having a high corrosion resistance are preferable because they can be easily formed. The thickness of the mirror element 153 only has to ensure a sufficient reflectance of 98% or more; in the case of a Ag film, for example, the thickness is preferably from 50 nm to 200 nm inclusive. The Faraday rotation angle can be increased by using the mirror element 153 to make light go back and forth within the Faraday rotator 152.

The circularly polarized light incident on the Faraday rotator 152 from the quarter-wave plate 151 is transmitted through the Faraday rotator 152, reflected by the mirror element 153, and transmitted through the Faraday rotator 152 again to become return light. The return light transmitted through the Faraday rotator 152 is incident on the quarter-wave plate 151 again.

The circularly polarized light incident on the Faraday rotator 152 from the quarter-wave plate 151 changes its phase according to the magnetic field applied to the Faraday rotator 152. The circularly polarized light reflected by the mirror element 153 further changes its phase according to the magnetic field applied to the Faraday rotator 152.

The beam splitter 150 is a polarizing beam splitter (PBS) of a prism type, a flat type, a wedge substrate type, an optical waveguide type, or the like, and separates the second linearly polarized-wave light having a sine waveform branching off from the circulator 120 into a P-polarized component and an S-polarized component.

The magnetic field signal generating circuit 160 receives the P-polarized component and the S-polarized component separated from the second linearly polarized-wave light by the beam splitter 150, converts them into electrical signals, and differentially amplifies them to output a first magnetic field signal Ed1 depending on the magnetic field applied to the first magnetic field sensor device 101.

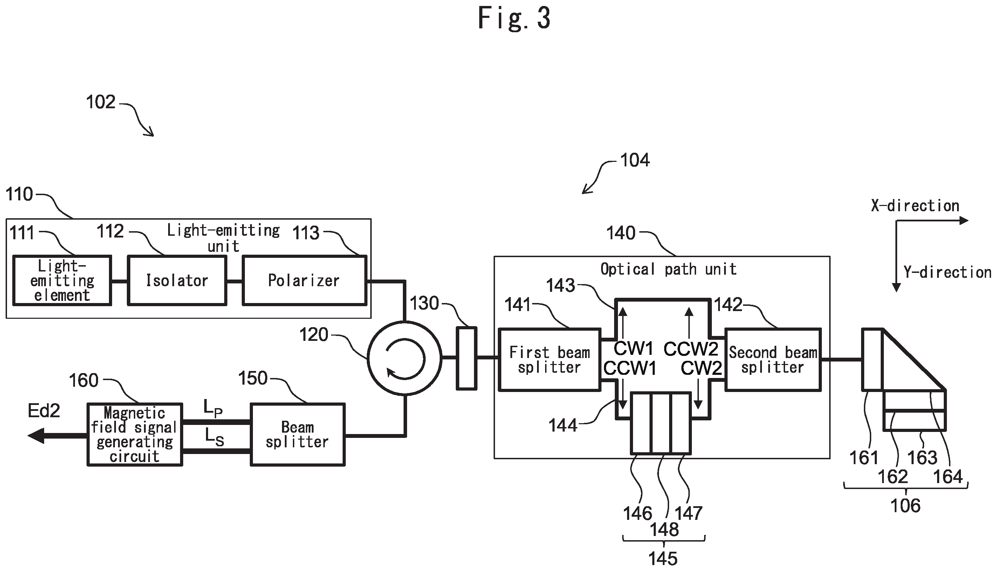

FIG. 3 is a block diagram of the second magnetic field sensor device 102.

The second magnetic field sensor device 102 differs from the first magnetic field sensor device 101 in that the former includes the second sensor head 106 instead of the first sensor head 105. Since the configurations and functions of the components of the second magnetic field sensor device 102 except the second sensor head 106 are the same as those of the components of the first magnetic field sensor device 101 assigned the same reference numerals, detailed description thereof is omitted herein. In the second magnetic field sensor device 102, a light-emitting unit 110, a circulator 120, a first optical element 130, an optical path unit 140, a beam splitter 150, and a magnetic field signal generating circuit 160 are housed in the second body 104. The second magnetic field sensor device 102 outputs a second magnetic field signal Ed2 depending on the magnetic field applied to the second magnetic field sensor device 102.

The second sensor head 106 includes a quarter-wave plate 161, a Faraday rotator 162, a mirror element 163, and an optical element 164, is connected to a second beam splitter 142 via a PANDA fiber, and is an element at least part of which can be disposed within a predetermined magnetic field. The second magnetic field sensor element 107 detects the X-component of a magnetic field generated by current flowing through the conductor 200. Since the configurations and functions of the quarter-wave plate 161, the Faraday rotator 162, and the mirror element 163 are the same as those of the quarter-wave plate 151, the Faraday rotator 152, and the mirror element 153, detailed description thereof is omitted herein. The optical element 164 is an element that reflects light, such as a mirror or a prism. The optical element 164 shifts light transmitted through the quarter-wave plate 161 by 90 degrees to a direction parallel to the Y-direction to make the light incident on the Faraday rotator 162, and also shifts light transmitted through the Faraday rotator 162 by 90 degrees to a direction parallel to the X-direction to make the light incident on the quarter-wave plate 161.

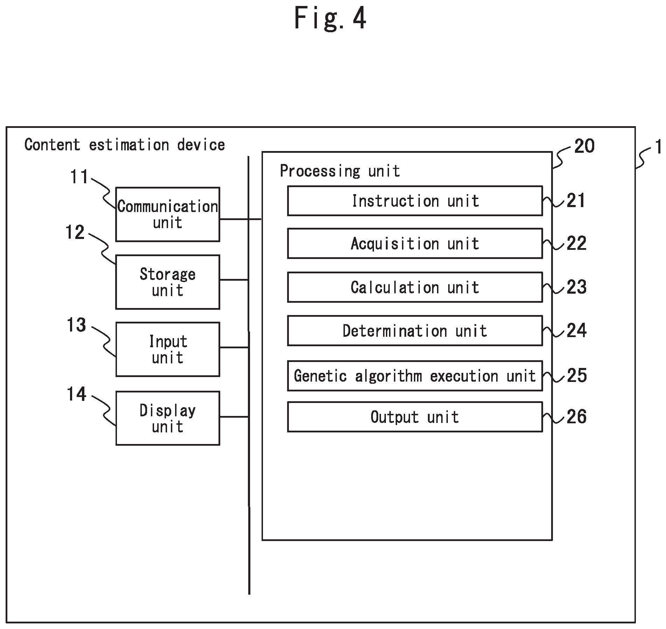

FIG. 4 is a block diagram of the current distribution estimation device 1 of the first embodiment.

The current distribution estimation device 1 includes a communication unit 11, a storage unit 12, an input unit 13, a display unit 14, and a processing unit 20, and executes various processes by referring to data and the like stored in the storage unit 12 on the basis of programs pre-stored in the storage unit 12. The current distribution estimation device 1 is an electronic computer that executes various processes in response to instructions inputted by an operator via the input unit 13 and that outputs the result of execution to the display unit 14. The current distribution estimation device 1 estimates the distribution of current supplied to the conductor 200 by substituting the current supplied to the conductor 200 with currents flowing through multiple micro-conductors with circular cross sections disposed adjacent to each other in a row in the second direction perpendicular to the first direction. The current distribution estimation device 1 estimates multiple currents generating a plurality of magnetic fields each corresponding to a first magnetic field signal Ed1 and a second magnetic field signal Ed2 on the basis of a genetic algorithm, and outputs a current signal indicating the estimated currents.

The communication unit 11 includes a communication interface circuit for connecting the current distribution estimation device 1 to a network (not shown). The communication unit 11 supplies the processing unit 20 with data received via the network from the first magnetic field sensor device 101, the second magnetic field sensor device 102, and an external device (not shown). In addition, the communication unit 11 transmits data supplied from the processing unit 20 to the first magnetic field sensor device 101, the second magnetic field sensor device 102, and the external device via the network. The communication unit 11 receives a first magnetic field signal Ed1 and a second magnetic field signal Ed2 from the first magnetic field sensor device 101 and the second magnetic field sensor device 102, respectively.

The storage unit 12 includes, for example, one of a semiconductor memory, a magnetic disk drive, and an optical disk drive. The storage unit 12 stores an operating system program, driver programs, application programs, data, and the like used for processing by the processing unit 20. For example, as driver programs, the storage unit 12 stores an input device driver program for controlling the input unit 13, an output device driver program for controlling the display unit 14, and the like. As an application program, the storage unit 12 stores a current distribution estimation program that causes the processing unit 20 to execute a current distribution estimation process for estimating a current distribution when current flows through the conductor 200. The current distribution estimation program may be installed into the storage unit 12 from a computer-readable portable storage medium, such as a CD-ROM or a DVD-ROM, using a known set-up program or the like. The storage unit 12 also stores various data used in current distribution estimation.

The input unit 13 may be any device that can operate the current distribution estimation device 1, and is, for example, a keyboard, a touch pad, or the like. An operator can input characters, numbers, and the like via the input unit 13. When operated by an operator, the input unit 13 generates a signal corresponding to the operation. The generated signal is supplied to the processing unit 20 as an instruction from the operator.

The display unit 14 may be any device that can display videos, images, characters, and the like, and is, for example, a liquid crystal display, an organic EL display, or the like. The display unit 14 displays videos, images, characters, and the like depending on video data, image data, and character data supplied from the processing unit 20. The display unit 14 may also display a graphical user interface for operating the current distribution estimation device 1.

The processing unit 20 includes one or more processors and peripheral circuits thereof. The processing unit 20 centrally controls the overall operation of the current distribution estimation device 1, and is, for example, a CPU. The processing unit 20 controls operations of the communication unit 11, the display unit 14, and the like so that various processes of the current distribution estimation device 1 are executed in an appropriate procedure according to programs stored in the storage unit 12, operation of the input unit 13, and the like. The processing unit 20 executes processes based on programs stored in the storage unit 12. The processing unit 20 can execute multiple programs in parallel.

The processing unit 20 includes an instruction unit 21, an acquisition unit 22, a calculation unit 23, a determination unit 24, a genetic algorithm execution unit 25, and an output unit 26. The genetic algorithm execution unit 25 is also referred to as an optimization unit. These units are functional modules implemented by a program executed by the processors included in the processing unit 20. Alternatively, these units may be implemented as firmware in the current distribution estimation device 1.

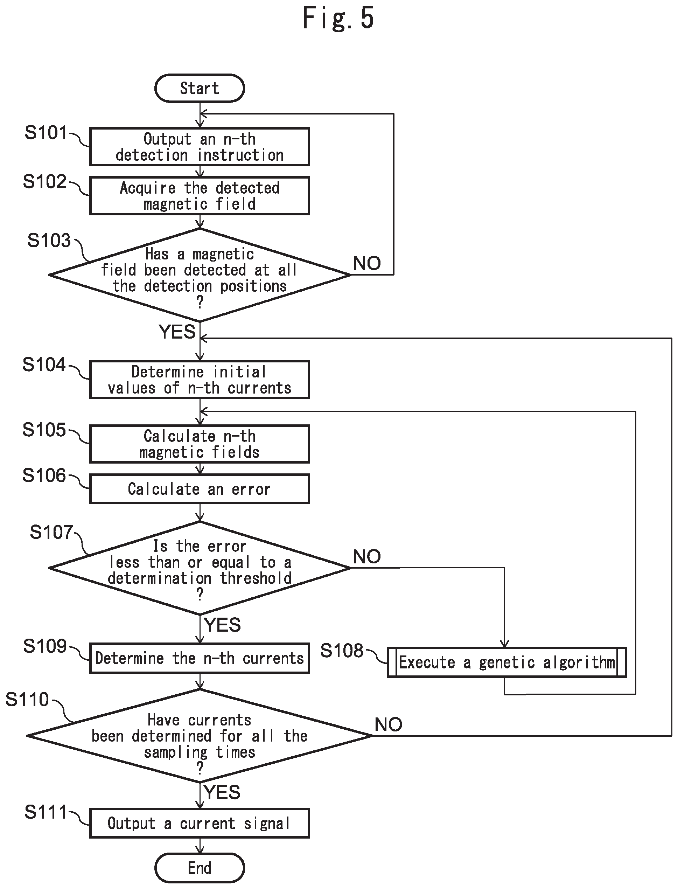

FIG. 5 is a flowchart of a current distribution estimation process executed by the current distribution estimation device 1. The current distribution estimation process shown in FIG. 5 is executed mainly by the processing unit 20 in cooperation with the components of the current distribution estimation system 100 on the basis of a current distribution estimation program pre-stored in the storage unit 12.

First, the instruction unit 21 outputs a first detection instruction to instruct of detecting a magnetic field at the first detection position $D_1$ to the first magnetic field sensor device 101, the second magnetic field sensor device 102, the current source 108, and the moving mechanism (not shown) (S101). In response to input of the first detection instruction, the moving mechanism (not shown) moves the first sensor head 105 and the second sensor head 106 to the first detection position $D_1$. In response to input of the first detection instruction, the current source 108 supplies the conductor 200 with a rising current whose current value rises from zero to a predetermined rated value. In response to input of the first detection instruction, the first magnetic field sensor device 101 and the second magnetic field sensor device 102 detect the X-component $H_X$ and the Y-component $H_Y$ of the magnetic field at the first detection position $D_1$ while the rising current is supplied to the conductor 200. The first magnetic field sensor device 101 and the second magnetic field sensor device 102 output a first magnetic field signal Ed1 and a second magnetic field signal Ed2 indicating the X-component $H_X$ and the Y-component $H_Y$ of the detected magnetic field to the current distribution estimation device 1.

Next, the acquisition unit 22 acquires the magnetic field detected at the first detection position (S102). The acquisition unit 22 acquires the X-component $H_X$ of the magnetic field corresponding to the first magnetic field signal Ed1 and the Y-component $H_Y$ of the magnetic field corresponding to the second magnetic field signal Ed2 at predetermined sampling intervals. The acquisition unit 22 stores X-component information indicating the X-component $H_X$ of the magnetic field and Y-component information indicating the Y-component $H_Y$ of the magnetic field in the storage unit 12 in association with an identifier indicating the first detection position $D_1$ and a first sampling time T1 to an M-th sampling time TM that are the times of sampling.

Next, the instruction unit 21 determines whether a magnetic field has been detected at all the detection positions up to the N-th detection position $D_N$ (S103). The instruction unit 21 does not determine that a magnetic field has been detected at all the detection positions up to the N-th detection position $D_N$ (S103-NO), and outputs a second detection instruction to detect a magnetic field at the second detection position $D_2$ (S101). Next, the acquisition unit 22 acquires the magnetic field detected at the second detection position (S102). Thereafter, the processing indicated by S101 to S103 is repeated until the instruction unit 21 determines that a magnetic field has been detected at all the detection positions up to the N-th detection position $D_N$ (S103-YES).

When it is determined that a magnetic field has been detected at all the detection positions up to the N-th detection position $D_N$ (S103-YES), the calculation unit 23 determines initial values of a first current $I_1$ to an N-th current $I_N$ flowing through the first detection position $D_1$ to the N-th detection position $D_N$, respectively, at the first sampling time (S104). The initial values of the first current $I_1$ to the N-th current $I_N$ may be any values, but are preferably determined according to the current value of the current supplied to the conductor 200. For example, the initial values of the first current $I_1$ to the N-th current $I_N$ may be current values obtained by equally dividing the total current supplied to the conductor 200.

Next, the calculation unit 23 calculates magnetic fields generated from the initial values of the first current $I_1$ to the N-th current $I_N$ respectively determined in the processing indicated by S104 (S105). First, the calculation unit calculates the magnetic field detected by the first sensor and the second sensor head 106 respectively disposed at the first detection position $D_1$ in response to the first current $I_1$ to the N-th current $I_N$ flowing through the first detection position $D_1$ to the N-th detection position $D_N$, respectively. The calculation unit 23 calculates the X-component $H_{1X}$ and the Y-component $H_{1Y}$ of a first magnetic field to the X-component $H_{NX}$ and the Y-component $H_{NY}$ of an N-th magnetic field generated from the initial values of the first current $I_1$ to the N-th current $I_N$ respectively. The X-component $H_{1X}$ and the Y-component $H_{1Y}$ of the first magnetic field are calculated by combining magnetic fields generated from the first current $I_1$ to the N-th current $I_N$ respectively.

An n-th magnetic field vector H(n) detected by the first sensor head 105 and the second sensor head 106 disposed at the first detection position $D_1$ in response to an n-th current I(n) flowing through each of the first detection position $D_1$ and the second detection position $D_2$ to the N-th detection position $D_N$ is represented by Expression (1).
[Expression 1]

$$\vec{H}(n) = \begin{pmatrix} H_X(n) \\ H_Y(n) \end{pmatrix} = \begin{pmatrix} H(n) \cdot \cos\theta'(n) \\ H(n) \cdot \sin\theta'(n) \end{pmatrix} \qquad (1)$$

$H_X(n)$ denotes the X-component of the magnetic field H(n), and $H_Y(n)$ denotes the Y-component of the magnetic field H(n). H(n) is assumed to be a magnetic field generated from currents flowing through multiple micro-conductors with circular cross sections, and is thus represented by Expression (2) based on Ampere's law; $\theta'$ is an angle in the range of $\pm 180$ degrees represented by Expression (3). In Expressions (2) and (3), height h denotes the distance in the X-direction from the center of the conductor 200 to the first sensor head 105 and the second sensor head 106, and width w(n) is the distance in the Y-direction between the first detection position $D_1$ and each of the second detection position $D_2$ to the N-th detection position $D_N$. I(n) is an initial value of currents at the second detection position $D_2$ to the N-th detection position $D_N$.
[Expression 2]

$$H(n) = \frac{I(n)}{2\pi\sqrt{h^2 + w(n)^2}} \qquad (2)$$

[Expression 3]

$$\theta'(n) = \frac{\pi}{2} + \tan^{-1}\left(\frac{w(n)}{h}\right) \qquad (3)$$

A magnetic field vector H(m) obtained by combining the n-th magnetic fields H(n) shown in Expression (1) is represented by Expression (4).
[Expression 4]

$$\vec{H}(m) = \sum_{k=2}^{n} \vec{H}(k) = \begin{pmatrix} H_X(m) \\ H_Y(m) \end{pmatrix} = \begin{pmatrix} \sum_{k=2}^{n} H_X(k) \\ \sum_{k=2}^{n} H_Y(k) \end{pmatrix} \qquad (4)$$

The magnitude of the composite magnetic field vector H(m) is represented by Expression (5); the angle of the composite magnetic field vector H(m) is represented by Expression (6).
[Expression 5]

$$H(m) = \sqrt{H_X(m)^2 + H_Y(m)^2} \qquad (5)$$

[Expression 6]

$$\theta'(m) = \frac{\pi}{2} + \tan^{-1}\left(\frac{H_X(m)}{H_Y(m)}\right) \qquad (6)$$

The calculation unit 23 stores the calculated magnitude and angle of the magnetic field vector H(m) in the storage unit 12 in association with an identifier indicating the first detection position $D_1$.
Next, the calculation unit 23 calculates the magnetic field detected by the first sensor head 105 and the second sensor head 106 disposed at the second detection position $D_2$ in response to n-th currents I(n) flowing through the first detection position $D_1$ to the N-th detection position $D_N$, respectively. As the magnetic field detected by the first sensor head 105 and the second sensor head 106 disposed at the second detection position $D_2$, the calculation unit 23 calculates the magnitude and angle of a composite magnetic field vector H(m), using Expressions (1) to (6). The calculation unit 23 stores the calculated magnitude and angle of the magnetic field vector H(m) in the storage unit 12 in association with an identifier indicating the second detection position $D_2$.
Thereafter, the calculation unit 23 sequentially calculates the magnetic fields detected by the first sensor head 105 and the second sensor head 106 disposed at the third detection position $D_3$ to the N-th detection position $D_N$, and stores the calculated magnetic fields in the storage unit 12.
Next, the calculation unit 23 calculates an error ε between the first magnetic field Hx,m(1) to the N-th magnetic field Hx,m(N) measured in the processing indicated by S101 to S103 and the first magnetic field Hx(1) to the N-th magnetic field Hx(N) calculated in the processing indicated by S105 (S106). The calculation unit 23 uses a least-squares method with Expression (7) to calculate an error ε between the measured first magnetic field Hx,m(1) to N-th magnetic field Hx,m(N) and the first magnetic field Hx(1) to the N-th magnetic field Hx(N) calculated in the processing indicated by S105. The calculation unit 23 stores error information indicating the calculated error ε in the storage unit 12.
[Expression 7]

$$\varepsilon = \sum_{m=1}^{m} \left( (H_{X,M}(m) - H_X(m))^2 - (H_{Y,M}(m) - H_Y(m))^2 \right) \qquad (7)$$

Next, the determination unit 24 determines whether the error ε calculated in the processing indicated by S106 is less than or equal to a predetermined determination threshold (S107). When it is determined that the error ε is not less than or equal to the determination threshold (S107-NO), the genetic algorithm execution unit 25 executes a genetic algorithm to optimize the first current $I_1$ to the N-th current $I_N$ used for calculating the magnetic fields in the processing indicated by S105 (S108).
Next, the calculation unit 23 calculates magnetic fields generated from the first current $I_1$ to the N-th current $I_N$ optimized in the processing indicated by S108 (S105). Thereafter, the processing indicated by S105 to S108 is repeated until it is determined that the error ε is less than or equal to the determination threshold (S107-NO).
When it is determined that the error ε is less than or equal to the determination threshold (S107-YES), the genetic algorithm execution unit 25 determines the first current $I_1$ to the N-th current $I_N$ optimized in the processing indicated by S108 as currents flowing through the conductor 200 at the first sampling time (S109). The output unit 26 stores current information indicating the first current $I_1$ to the N-th current $I_N$ respectively in the storage unit 12 in association with identifiers indicating the first detection position $D_1$ to the N-th detection position $D_N$ respectively and the first sampling time T1.

Next, the calculation unit 23 determines whether the first current $I_1$ to the N-th current $I_N$ have been determined for all the sampling times (S110). When it is determined that the first current $I_1$ to the N-th current $I_N$ have not been determined for all the sampling times (S110-NO), the calculation unit 23 determines initial values of the first current $I_1$ to the N-th current $I_N$ for the second sampling time (S104). The calculation unit 23 determines initial values of the first current $I_1$ to the N-th current $I_N$ for the second sampling time, as in the processing for the first sampling time. Thereafter, the processing indicated by S104 to S110 is repeated until the calculation unit 23 determines that the first current $I_1$ to the N-th current $I_N$ have been determined for all the sampling times (S110-YES).

When it is determined that the first current $I_1$ to the N-th current $I_N$ have been optimized for all the sampling times (S110-YES), the output unit 26 outputs a current signal indicating the first current $I_1$ to the N-th current $I_N$ determined in the processing indicated by S109 to the display unit 14 (S111). The output unit 26 acquires current information indicating the first current $I_1$ to the N-th current $I_N$ for each of the first sampling time T1 to the M-th sampling time TM, and outputs a current signal corresponding to the acquired current information to the display unit 14. The display unit 14 displays the first current $I_1$ to the N-th current $I_N$ corresponding to the inputted current signal.

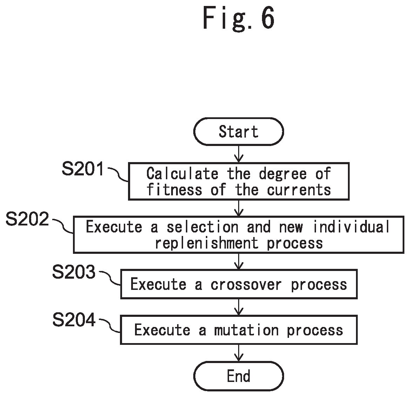

FIG. 6 is a flowchart showing the processing indicated by S108 in more detail.

First, the genetic algorithm execution unit 25 calculates the degree of fitness of the first current $I_1$ to the N-th current $I_N$ (S201). The genetic algorithm execution unit 25 calculates the absolute values of the errors between the first magnetic field H(1) to the N-th magnetic field H(N) calculated in the processing indicated by S105 and the first magnetic field Hm(1) to the N-th magnetic field Hm(N) measured in the processing indicated by S101 to S103. Next, the genetic algorithm execution unit 25 calculates an average of the absolute values of the errors between the calculated first magnetic field H(1) to N-th magnetic field H(N) and the first magnetic field Hm(1) to the N-th magnetic field Hm(N).

Next, the genetic algorithm execution unit 25 executes a selection and new individual replenishment process (S202). The genetic algorithm execution unit 25 randomly selects 50% of n-th currents I(n) corresponding to n-th magnetic fields H(n) whose average of the absolute values of the errors is greater than the average of the absolute values of the errors. Next, the genetic algorithm execution unit 25 randomly chooses n-th currents I(n) corresponding to n-th magnetic fields H(n) that are less than or equal to the average of the absolute values of the errors, and replaces the selected n-th currents I(n) with currents obtained by mutating the chosen n-th currents I(n) in the range of 80% to 120%.

Next, the genetic algorithm execution unit 25 executes a crossover process (S203). For a predetermined number of n-th currents I(n), the genetic algorithm execution unit 25 chooses a pair of n-th currents I(n) that are genes of randomly chosen parents, and then executes a crossover process by uniform crossover.

Next, the genetic algorithm execution unit 25 executes a mutation process (S204). The genetic algorithm execution unit 25 executes a mutation process by mutating 10% of the n-th currents I(n) subjected to the crossover process in the range of 50% to 150%.

The current distribution estimation device 1 can estimate a current distribution of a conductor 200 with high accuracy by estimating current inside the conductor 200 on the basis of the genetic algorithm.

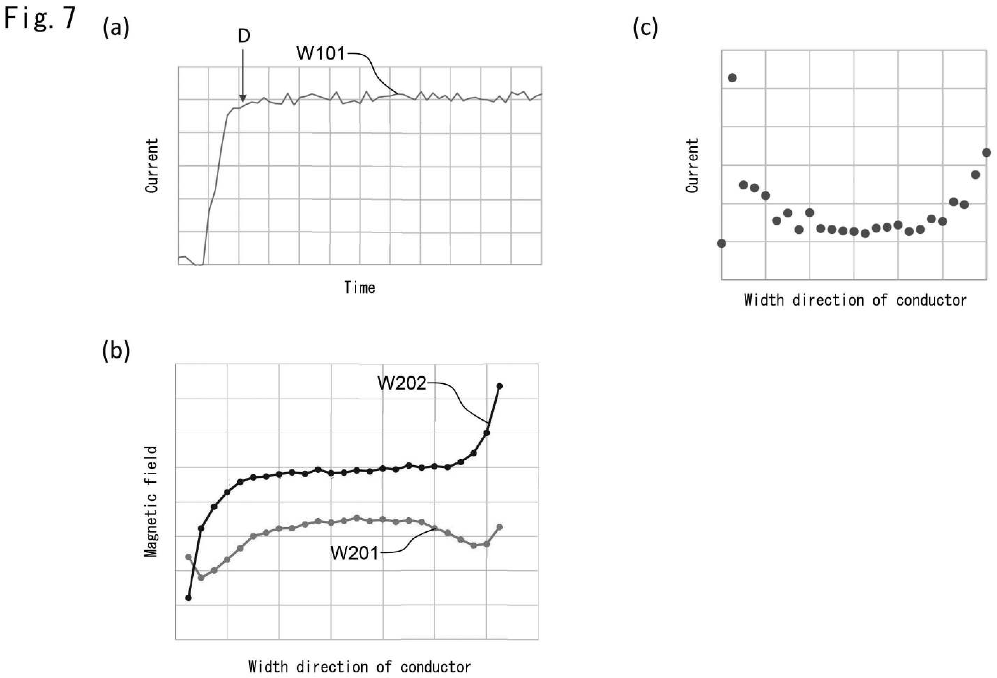

FIG. 7(a) shows time-varying changes in current supplied to the conductor 200 from the current source 108. FIG. 7(b) shows the magnetic field distribution in the width direction of the conductor 200 at the time indicated by arrow D in FIG. 7(a); FIG. 7(c) shows the result of current distribution estimation by the current distribution estimation device 1 corresponding to FIG. 7(b). In FIG. 7(a), the horizontal axis represents time, the vertical axis represents current supplied to the conductor 200, and a waveform W101 represents time-varying changes in the total current supplied to the conductor 200. In FIG. 7(b), the horizontal axis represents the position in the width direction of the conductor 200, and the vertical axis represents the magnetic field. A waveform W201 shows time-varying changes in the magnetic field detected by the first magnetic field sensor device 101 when current is supplied to the conductor 200; a waveform W202 shows time-varying changes in the magnetic field detected by the second magnetic field sensor device 102 when current is supplied to the conductor 200. In FIG. 7(c), the horizontal axis represents the position in the width direction of the conductor 200, the vertical axis represents current, and dots represent currents estimated by the current distribution estimation device 1. In FIGs. 7(a) to 7(c), a metal flat plate having a width of 12 mm and a thickness of 0.5 mm was used as the conductor 200; the detection pitch was 1 mm; the current supplied to the conductor 200 was a pulse wave having an amplitude of 100 A and a slew rate of 15 A/μs.

As shown in FIG. 7(c), the current distribution estimation device 1 detects that the current at the edges of the conductor 200 is greater than the current at the center of the conductor 200 because of the skin effect at the time indicated by arrow D, which is the rising edge of the current supplied to the conductor 200. The current distribution estimation device 1 can estimate the current distribution inside the conductor 200 with high accuracy.

FIG. 8 is a block diagram of a current distribution estimation device of a second embodiment. Like the current distribution estimation device 1, the current distribution estimation device 2 is disposed in the current distribution estimation system 100, and estimates the distribution of current flowing through a flat conductor 200 on the basis of a gradient descent method.

The current distribution estimation device 2 differs from the current distribution estimation device 1 in that the former includes a processing unit 30 instead of the processing unit 20. The processing unit 30 differs from the processing unit 20 in that the former includes a gradient descent process execution unit 35, also referred to as an optimization unit, instead of the genetic algorithm execution unit 25. Since the configurations and functions of the components of the current distribution estimation device 2 except the gradient descent process execution unit 35 are the same as those of the components of the current distribution estimation device 1 assigned the same reference numerals, description thereof is omitted herein.

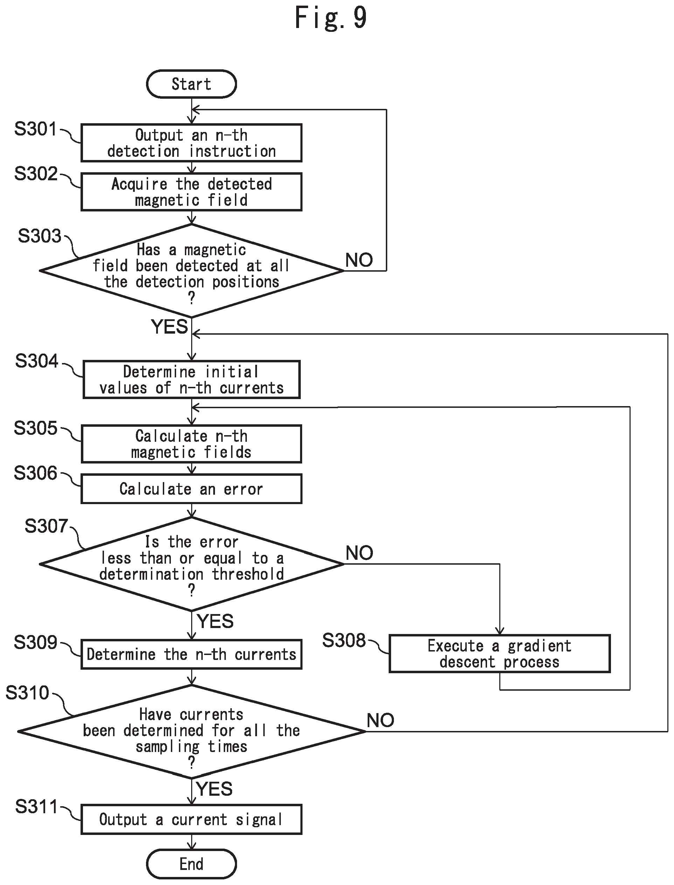

FIG. 9 is a flowchart of a current distribution estimation process executed by the current distribution estimation device 2. The current distribution estimation process shown in FIG. 9 is executed mainly by the processing unit 30 in cooperation with the components of the current distribution estimation system 100 on the basis of a current distribution estimation program pre-stored in the storage unit 12. Since the processing indicated by S301 to S307 is similar to the processing indicated by S101 to S107, detailed description thereof is omitted herein.

When it is determined that the error $\varepsilon$ is not less than or equal to the determination threshold (S307-NO), the gradient descent process execution unit 35 executes a gradient descent process to optimize the first current $I_1$ to the N-th current $I_N$ used for calculating magnetic fields in the processing indicated by S305 (S308).

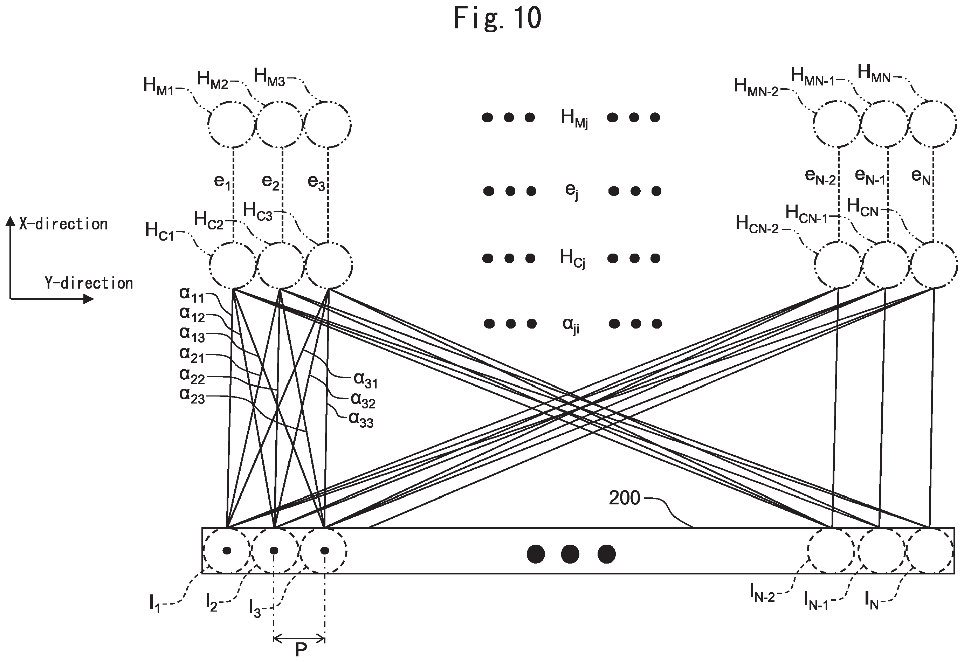

FIG. 10 is a diagram for explaining the gradient descent process indicated by S308. In FIG. 10, a first current $I_1$ to an N-th current $I_N$ indicate currents flowing through the first detection position $D_1$ to the N-th detection position $D_N$ in the conductor 200. A first calculated magnetic field $H_{C1}$ to an N-th calculated magnetic field $H_{CN}$ are calculated values of the first magnetic field $H_1$ to the N-th magnetic field $H_N$ detected by the first sensor head 105 and the second sensor head 106 at the first detection position $D_1$ to the N-th detection position $D_N$, respectively. A first measured magnetic field $H_{M1}$ to an N-th measured magnetic field $H_{MN}$ are measured values of the first magnetic field $H_1$ to the N-th magnetic field $H_N$ detected by the first sensor head 105 and the second sensor head 106 at the first detection position $D_1$ to the N-th detection position $D_N$, respectively.

The j-th calculated magnetic field $H_{Cj}$ is represented by the sum of values obtained by multiplying the first current $I_1$ to the N-th current $I_N$ respectively by weighting factors $\alpha_{ji}$, and is represented by Expression (8).
[Expression 8]

$$H_j = \sum_{i=1}^{N} \alpha_{ji} \cdot I_i \quad (8)$$

The weighting factors $\alpha_{ji}$ are factors representing the magnetic field generated from the first current $I_1$ to the N-th current $I_N$ by Ampere's law, and are variables having height h and horizontal distance $w_{M1}$ as parameters and represented by Expression (9).
[Expression 9]

$$\alpha_{ji} = \frac{\sqrt{2}\left\{\frac{3}{4}\pi - \tan^{-1}\left(\frac{h}{w_{ji}}\right)\right\}}{2\pi\sqrt{h^2 + w_{ji}^2}} \quad (9)$$

The height h is the distance from the first sensor head 105 and the second sensor head 106 to the center of the conductor 200. The horizontal distance $w_{ji}$ is the separation distance in the Y-direction, i.e., the horizontal direction, between the i-th detection position $D_i$ and the first detection position $D_1$ to the N-th detection position $D_N$. For example, the horizontal distance $w_{12}$ between the first detection position $D_1$ and the second detection position $D_2$ is twice the detection pitch P; the horizontal distance $w_{1N}$ between the first detection position $D_1$ and the N-th detection position $D_N$ is N times the detection pitch P.

A j-th error $\varepsilon_j$, which is an error between the first measured magnetic field $H_{M1}$ to the N-th measured magnetic field $H_{MN}$ and the first calculated magnetic field $H_{C1}$ to the N-th calculated magnetic field $H_{CN}$, is the mean square error of the differences between the first measured magnetic field $H_{M1}$ to the N-th measured magnetic field $H_{MN}$ and the first calculated magnetic field $H_{C1}$ to the N-th calculated magnetic field $H_{CN}$ respectively, and is represented by Expression (10).
[Expression 10]

$$e_j = \frac{1}{2}\left(H_{Mj} - H_{Cj}\right)^2 \quad (10)$$

The loss function, i.e., the objective function, of the gradient descent process is the sum E of the errors $\varepsilon_i$ between the first measured magnetic field $H_{M1}$ to the N-th measured magnetic field $H_{MN}$ and the first calculated magnetic field $H_{C1}$ to the N-th calculated magnetic field $H_{CN}$, and is represented by Expression (11).
[Expression 11]

$$E = \sum_{j=1}^{N} e_j \quad (11)$$

In the gradient descent process, each of the first current $I_1$ to the N-th current $I_N$ is sequentially updated by subtracting a value obtained by multiplying the gradient of each of the first current $I_1$ to the N-th current $I_N$, which is calculated by partial differential of the error $e_j$ included in the objective function E shown in Expression (11), by a step size $\eta$ from each of the first current $I_1$ to the N-th current $I_N$. The partial differential of the error $e_j$ is represented by Expression (12). As represented by Expression (12), it is the product of the partial differential $\delta_j$ of the j-th error $\varepsilon_i$ with respect to the j-th calculated magnetic field $H_{Cj}$ and the partial differential of the j-th calculated magnetic field $H_{Cj}$ with respect to the j-th measured magnetic field $H_{Mj}$ on the basis of the chain rule.
[Expression 12]

$$\frac{\partial e_j}{\partial I_i} = \sum_{j=1}^{N} \frac{\partial e_j}{\partial H_{Cj}} \cdot \frac{\partial H_{Cj}}{\partial I_i} \quad (12)$$

The partial differential of the j-th error $\varepsilon_i$ with respect to the j-th calculated magnetic field $H_{Cj}$ is represented by Expression (13); the partial differential of the j-th calculated magnetic field $H_{Cj}$ with respect to the j-th measured magnetic field $H_{Mj}$ is represented by Expression (14).
[Expression 13]

$$\frac{\partial e_j}{\partial H_{Cj}} = -\left(H_{Mj} - H_{Cj}\right) = \delta_j \quad (13)$$

[Expression 14]

$$\frac{\partial H_{Cj}}{\partial I_i} = \alpha_{ji} \cdot \frac{\partial I_i}{\partial I_i} = \alpha_{ji} \quad (14)$$

From the above, the i-th gradient ($\partial \varepsilon_i / \partial I_i$) is represented by Expression (15).
[Expression 15]

$$\frac{\partial e_j}{\partial I_i} = \sum_{j=1}^{N} \delta_j \cdot \alpha_{ji} \quad (15)$$

In the gradient descent process indicated by S308, each of the first current $I_1$ to the N-th current $I_N$ is calculated according to the i-th gradient ($\partial \varepsilon_i / \partial I_i$) and a learning rate, also referred to as a step size, as represented by the i-th current $I_i$

in Expression (16), every time the gradient descent process is executed. In Expression (16), $(I_i)_{PRESENT}$ denotes the i-th current $I_j$ used in the gradient descent process, and $(I_i)_{NEW}$ denotes the i-th current $I_i$ to be used in the next gradient descent process.

[Expression 16]

$$(I_i)_{\text{new}} = (I_i)_{\text{present}} - \eta \left( \frac{\partial e_j}{\partial I_i} \right) \quad (16)$$

When it is determined that the error $\varepsilon$ is less than or equal to the determination threshold (S307-YES), the gradient descent process execution unit 35 determines the first current $I_1$ to the N-th current $I_N$ optimized in the processing indicated by S308 as currents flowing through the conductor 200 at the first sampling time (S309). Since the processing indicated by S310 and S311 is similar to the processing indicated by S110 and S111, detailed description thereof is omitted herein.

The current distribution estimation device 2 can estimate a current distribution of a conductor 200 with high accuracy by estimating current inside the conductor 200 on the basis of the gradient descent method.

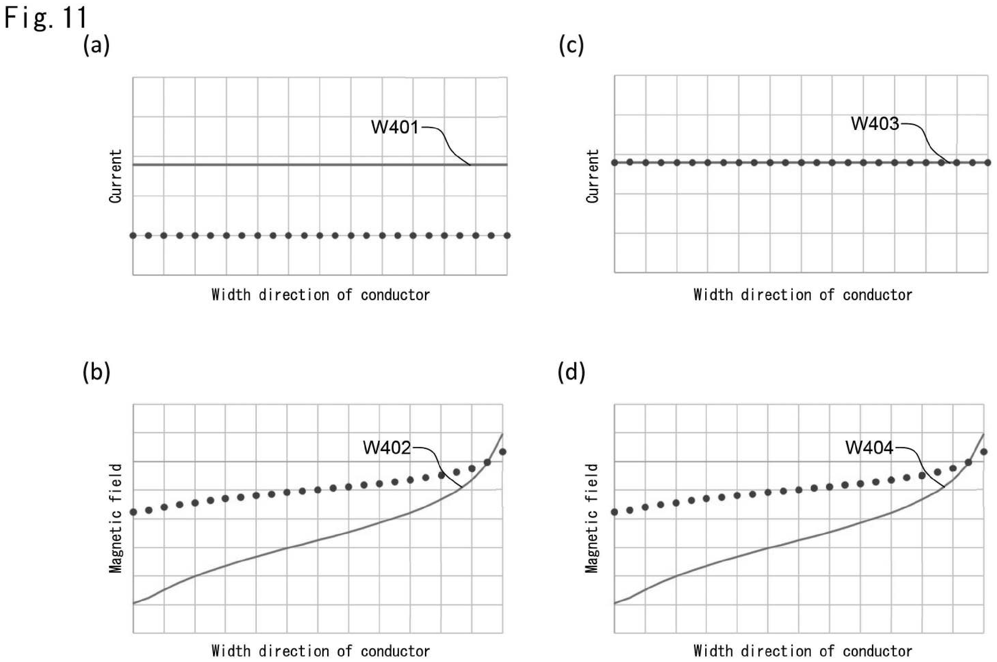

FIG. 11 shows the result (part 1) of current distribution estimation by the current distribution estimation device 2. FIG. 11(a) shows the relationship between a target current and initial values of the first current $I_1$ to the N-th current $I_N$; FIG. 11(b) shows the relationship between a first magnetic field $H_1$ to an N-th magnetic field $H_N$ corresponding to the initial values of the first current $I_1$ to the N-th current $I_N$ and a target magnetic field. FIG. 11(c) shows the relationship between the target current and estimated values of the first current $I_1$ to the N-th current $I_N$; FIG. 11(d) shows the relationship between a first magnetic field $H_1$ to an N-th magnetic field $H_N$ corresponding to the estimated values of the first current $I_1$ to the N-th current $I_N$ and the target magnetic field.

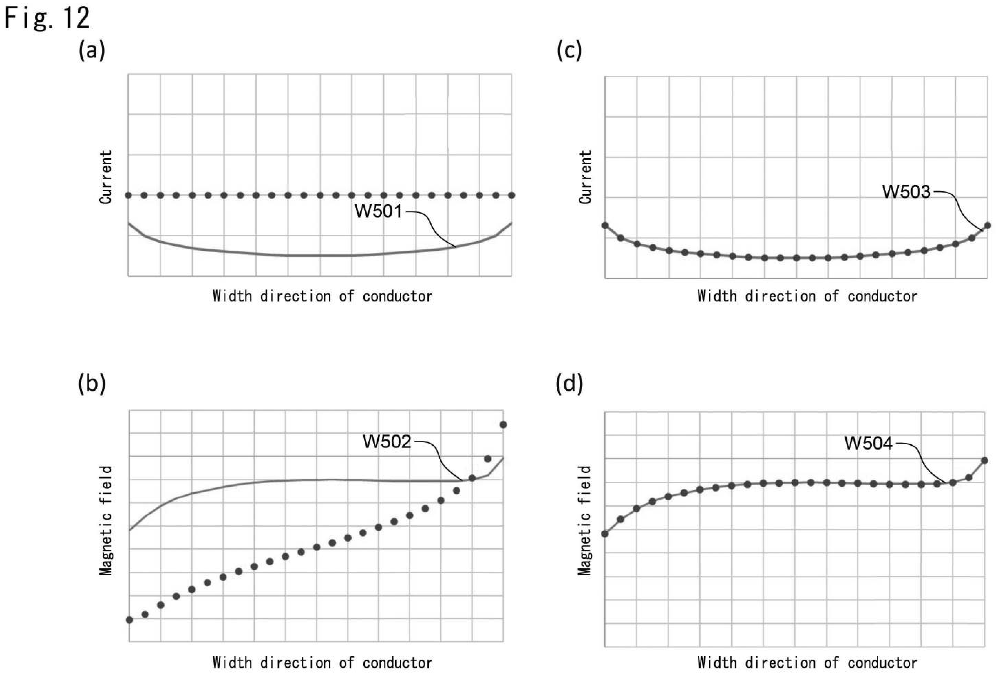

FIG. 12 shows the result (part 2) of current distribution estimation by the current distribution estimation device 2. FIG. 12(a) shows the relationship between a target current and initial values of the first current $I_1$ to the N-th current $I_N$; FIG. 12(b) shows the relationship between a first magnetic field $H_1$ to an N-th magnetic field $H_N$ corresponding to the initial values of the first current $I_1$ to the N-th current $I_N$ and a target magnetic field. FIG. 12(c) shows the relationship between the target current and estimated values of the first current $I_1$ to the N-th current $I_N$; FIG. 12(d) shows the relationship between a first magnetic field $H_1$ to an N-th magnetic field $H_N$ corresponding to the estimated values of the first current $I_1$ to the N-th current $I_N$ and the target magnetic field.

In FIGs. 11(a) to 11(d) and FIGs. 12(a) to 12(d), the horizontal axis represents the position in the width direction of the conductor 200. In FIGs. 11(a), 11(c), 12(a), and 12(c), the vertical axis represents current; in FIGs. 11(b), 11(d), 12(b) and 12(d), the vertical axis represents the magnetic field. In FIGs. 11(a) and 12(a), dots represent initial values of the first current $I_1$ to the N-th current $I_N$; in FIG. 11(a), a waveform W401 represents a target current; in FIG. 12(a), a waveform W501 represents a target current. In FIGs. 11(b) and 12(b), dots represent a first magnetic field $H_1$ to an N-th magnetic field $H_N$ corresponding to the initial values of the first current $I_1$ to the N-th current $I_N$; in FIG. 11(b), a waveform W402 represents a target magnetic field; in FIG. 12(b), a waveform W502 represents a target magnetic field. In FIGs. 11(c) and 12(c), dots represent estimated values of the first current $I_1$ to the N-th current $I_N$; in FIG. 11(c), a waveform W403 represents the target current; in FIG. 12(a), a waveform W503 represents the target current. In FIGs. 11(d) and 12(d), dots represent a first magnetic field $H_1$ to an N-th magnetic field $H_N$ corresponding to the estimated values of the first current $I_1$ to the N-th current $I_N$; in FIG. 11(d), a waveform W404 represents the target magnetic field; in FIG. 12(d), a waveform W504 represents the target magnetic field.

The current distribution estimation process shown in FIGs. 11 and 12 was executed by repeating the gradient descent process 100 times with a step size $\eta$ of $1.0 \times 10^{-6}$.

As shown in FIGs. 11 and 12, execution of current distribution estimation by the current distribution estimation device 2 enables the first current $I_1$ to the N-th current $I_N$ to be estimated so that the first magnetic field $H_1$ to the N-th magnetic field $H_N$ match the target magnetic field, thereby enabling the first current $I_1$ to the N-th current $I_N$ to match the target values.

FIG. 13 shows the result (part 3) of current distribution estimation by the current distribution estimation device 2. FIG. 13(a) shows time-varying changes in the total current supplied to the conductor 200 from the current source 108; FIG. 13(b) shows time-varying changes in estimated values of the total current supplied to the conductor 200 from the current source 108. FIG. 13(c) shows time-varying changes (part 1) in estimated values of the distribution of the current supplied to the conductor 200 from the current source 108; FIG. 13(d) shows time-varying changes (part 2) in estimated values of the distribution of the current supplied to the conductor 200 from the current source 108. In FIGs. 13(a) and 13(b), the horizontal axis represents time, and the vertical axis represents current. In FIG. 13(a), a waveform W601 represents time-varying changes in the current supplied to the conductor 200 from the current source 108; in FIG. 13(b), a waveform W602 represents time-varying changes in estimated values of the current supplied to the conductor 200 from the current source 108. The waveform W602 is integral values of the first current $I_1$ to the N-th current $I_N$. In FIGs. 13(c) and 13(d), the first horizontal axis represents the position in the width direction of the conductor 200, the second horizontal axis represents time, and the vertical axis represents current.

The current distribution estimation process shown in FIG. 13 was executed by repeating the gradient descent process 1000 times with a step size $\eta$ of $1.0 \times 10^{-8}$.

As shown in FIG. 13(b), execution of current distribution estimation by the current distribution estimation device 2 enables reproduction of the time-varying changes in the current supplied to the conductor 200 from the current source 108. In addition, as indicated by arrows E in FIGs. 13(c) and (d), execution of current distribution estimation by the current distribution estimation device 2 results in detection that the current at the edges of the conductor 200 is greater than the current at the center of the conductor 200 because of the skin effect. The current distribution estimation device 2 can estimate the current distribution inside the conductor 200 with high accuracy.

In addition, the current distribution estimation device 2, which optimizes current supplied to the conductor 200 on the basis of a gradient descent method, can execute the optimization process in fewer steps than the current distribution estimation device 1, which optimizes current supplied to the conductor 200 on the basis of a genetic algorithm. By executing the optimization process in fewer steps than the current distribution estimation device 1, the current distribution estimation device 2 can execute the optimization process faster than the current distribution estimation device 1.

The current distribution estimation device 2 calculates the error between the plurality of magnetic fields acquired by the acquisition unit 22 and the plurality of magnetic fields calculated by the calculation unit 23 as a mean square error. Calculating the error as a mean square error enables the current distribution estimation device 2 to treat the partial differential $\delta_j$ of the j-th error $\varepsilon_i$ with respect to the j-th calculated magnetic field $H_{Cj}$ as a coefficient proportional to the difference between the j-th calculated magnetic field $H_{Cj}$ and the j-th measured magnetic field $H_{Mj}$. Treating the partial differential $\delta_j$ of the j-th error $\varepsilon_i$ with respect to the j-th calculated magnetic field $H_{Cj}$ as a coefficient proportional to the difference between the j-th calculated magnetic field $H_{Cj}$ and the j-th measured magnetic field $H_{Mj}$ enables the current distribution estimation device 2 to simplify calculation of the optimization process to speed up the optimization process.

The current distribution estimation devices 1 and 2 repeat the process of optimizing the first current $I_1$ to the N-th current $I_N$ until it is determined that the error $\varepsilon$ is less than or equal to the determination threshold; however, the current distribution estimation current device unit of the embodiment may terminate the optimization process after a predetermined number of iterations.

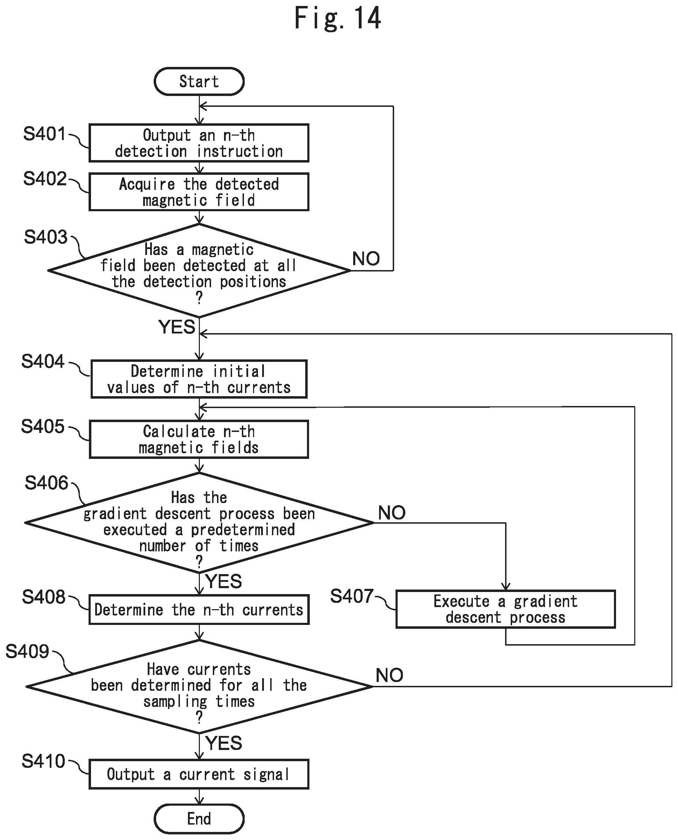

FIG. 14 is a flowchart of a current distribution estimation process of a modified example executed by the current distribution estimation device 2. The current distribution estimation process shown in FIG. 14 is executed mainly by the processing unit 30 in cooperation with the components of the current distribution estimation system 100 on the basis of a current distribution estimation program pre-stored in the storage unit 12. Since the processing indicated by S401 to S405 is similar to the processing indicated by S101 to S105, detailed description thereof is omitted herein.

Following the processing indicated by S405, the determination unit 24 determines whether the gradient descent process has been executed a predetermined number of times (S406), thereby determining whether the plurality of magnetic fields acquired by the acquisition unit 21 matches the plurality of magnetic fields calculated by the calculation unit 23. When the determination unit 24 determines that the gradient descent process has not been executed a predetermined number of times (S406-NO), the gradient descent process execution unit 35 executes the gradient descent process (S407). Thereafter, the processing indicated by S405 to S407 is repeated until the determination unit 24 determines that the gradient descent process has been executed a predetermined number of times (S406-YES). When the determination unit 24 determines that the gradient descent process has been executed a predetermined number of times (S406-YES), the gradient descent process execution unit 35 determines the first current $I_1$ to the N-th current $I_N$ optimized in the processing indicated by S307 as currents flowing through the conductor 200 (S408). Since the processing indicated by S409 and S410 is similar to the processing indicated by S110 and S111, detailed description thereof is omitted herein.

The current distribution estimation devices 1 and 2 estimate the distribution of current supplied to a single flat conductor 200; however, the current distribution estimation device of the embodiment may estimate the distribution of current supplied to multiple conductors. The current distribution estimation device 1 and 2 estimate the distribution of current supplied to a conductor 200 by substituting the current supplied to the conductor 200 with currents flowing through multiple micro-conductors with circular cross sections disposed adjacent to each other in a row in the second direction perpendicular to the first direction. However, the current distribution estimation device of the embodiment may estimate the distribution of current supplied to a conductor 200 by substituting the current with currents flowing through multiple micro-conductors with circular cross sections disposed adjacent to each other in multiple rows in the second direction.

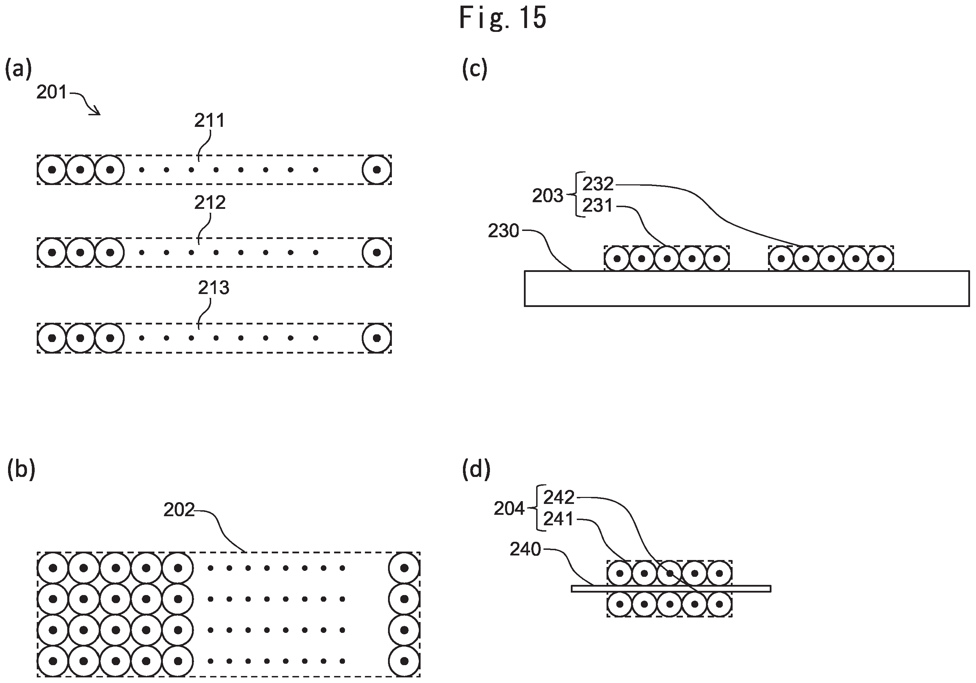

FIG. 15(a) shows a conductor of a first modified example; FIG. 15(b) shows a conductor of a second modified example; FIG. 15(c) shows a conductor of a third modified example; FIG. 15(d) shows a conductor of a fourth modified example.

A conductor 201 of a first modified example is formed of three flat conductors 211 to 213 disposed so that their surfaces face each other. The current distribution estimation system of the embodiment estimates the distribution of currents flowing through the conductors 211 to 213 according to magnetic fields detected by the first sensor head 105 and the second sensor head 106 scanning the surface of the conductor 211.

As for a conductor 202 of a second modified example, the current distribution estimation system of the embodiment estimates the distribution of current supplied to the conductor 202 by substituting the current with currents flowing through multiple micro-conductors with circular cross sections disposed in several rows in the conductor 202.

A conductor 203 of a third modified example includes a pair of conductive patterns 231 and 232 formed on a circuit board 230. The current distribution estimation system of the embodiment detects magnetic fields by the first sensor head 105 and the second sensor head 106 scanning the surfaces of the conductive patterns 231 and 231 from an outer edge of the conductive pattern 231 to an outer edge of the conductive pattern 232. The current distribution estimation system of the embodiment estimates the distribution of current flowing through the conductive patterns 231 and 232 according to the detected magnetic fields.

A conductor 201 of a fourth modified example is formed of a bus bar 241 disposed on one surface of a thin film 240 and a bus bar 242 disposed on the other surface of the thin film 240. The current distribution estimation system of the embodiment estimates the distribution of current flowing through the bus bars 241 and 242 according to magnetic fields detected by the first sensor head 105 and the second sensor head 106 scanning the surface of the bus bar 241.

The current distribution estimation devices 1 and 2 estimate the distribution of current supplied to a flat conductor 200; however, the current distribution estimation device of the embodiment may estimate the distribution of current supplied to a conductor having unevenness or the like in which the current is unevenly distributed.

The current distribution estimation device 1 optimizes current supplied to a conductor 200 on the basis of a genetic algorithm; the current distribution estimation device 2 optimizes current supplied to a conductor 200 on the basis of a gradient descent method. However, the current distribution estimation device of the embodiment may optimize current supplied to a conductor 200 on the basis of an optimization algorithm other than the genetic algorithm and the gradient descent method. For example, the current distribution estimation device of the embodiment may optimize current supplied to a conductor 200 on the basis of a local search method such as a hill-climbing method or a simulated annealing method.

The current distribution estimation device 2 calculates the j-th error $\varepsilon_i$ as a mean square error; however, the j-th error $\varepsilon_i$ of the current distribution estimation device of the embodiment is not limited to a mean square error, and only has to be calculated using a least-squares method.

The current distribution estimation system 100 detects a plurality of magnetic fields by the first sensor head 105 and the second sensor head 106 scanning the surface of the conductor 200 in the second direction perpendicular to the first direction in which current flows. However, the current distribution estimation system of the embodiment only has to detect magnetic fields at detection positions that do not overlap in the second direction.

The current distribution estimation system 100 includes the first magnetic field sensor device 101 and the second magnetic field sensor device 102; however, since detected magnetic fields in the X- and Y-directions are in a differential relationship and correlated, the current distribution estimation system of the embodiment may include only a single magnetic field sensor device.

The current distribution estimation method of the present disclosure may be configured in the following modes.

(Mode 1)

A method for estimating a current distribution of current flowing through a conductor, the method comprising:

an initial condition process for setting initial conditions such as arrangement and dimensions of the conductor and magnetic field measurement positions;
a calculation process for calculating a magnetic field generated at any location around the conductor treated as a collection of circular conductors;
an evaluation process for evaluating an error between magnetic field vector information obtained by measuring a magnetic field generated at any location around the conductor and magnetic field vector information obtained by the calculation process; and
an optimization process for optimizing the current distribution and the measurement positions.

(Mode 2)

The method according to mode 1, wherein a least-squares method that averages the magnetic field vector information in two directions perpendicular to the direction of current flow is used as the result of evaluation.

(Mode 3)

The method according to mode 1 or 2, wherein optimization by a local search algorithm or a genetic algorithm is used to determine an optimal solution of the current distribution.

**Claims**

1. A current distribution estimation device comprising:

   an acquisition unit that acquires magnetic field signals respectively indicating a plurality of magnetic fields detected at a plurality of detection positions on a surface of a conductor through which current flows;
   an optimization unit that optimizes, based on a predetermined optimization algorithm, current that generates magnetic fields detected at the plurality of detection positions, respectively;
   a calculation unit that calculates a plurality of magnetic fields generated at the plurality of detection positions by current optimized by the optimization unit;
   a determination unit that determines whether the plurality of magnetic fields acquired by the acquisition unit matches the plurality of magnetic fields calculated by the calculation unit; and
   an output unit that outputs a current signal indicating the current optimized by the optimization unit, when the determination unit determines that the plurality of magnetic fields acquired by the acquisition unit matches the plurality of magnetic fields calculated by the calculation unit.

2. The current distribution estimation device according to claim 1, wherein the calculation unit determines an initial value of the current that generates magnetic fields detected at the plurality of detection positions, respectively, and the optimization unit optimizes the initial value.

3. The current distribution estimation device according to claim 1, wherein the calculation unit calculates each of the plurality of magnetic fields by assuming that the current that generates magnetic fields detected at the plurality of detection positions, respectively, is a current flowing through a conductor with a circular cross section.

4. The current distribution estimation device according to any one of claims 1 to 3, wherein the optimization unit optimizes the current, based on a genetic algorithm, a gradient descent method, or a local search method.

5. The current distribution estimation device according to claim 4, wherein the optimization unit optimizes the current, based on a gradient descent method.

6. The current distribution estimation device according to claim 5, wherein the optimization unit uses a least-squares method to calculate an error between the plurality of magnetic fields acquired by the acquisition unit and the plurality of magnetic fields calculated by the calculation unit.

7. A current distribution estimation method comprising:

   acquiring magnetic field signals respectively indicating a plurality of magnetic fields detected at a plurality of detection positions on a surface of a conductor through which current flows;
   optimizing, based on a predetermined optimization algorithm, current that generates magnetic fields detected at the plurality of detection positions, respectively;
   calculating a plurality of magnetic fields generated at the plurality of detection positions by the optimized current;
   determining whether the acquired plurality of magnetic fields matches the calculated plurality of magnetic fields; and
   outputting a current signal indicating the optimized current, when it is determined that the acquired plurality of magnetic fields matches the calculated plurality of magnetic fields.

8. A current distribution estimation program causing a computer to execute a process comprising:

   acquiring magnetic field signals respectively indicating a plurality of magnetic fields detected at a plurality of detection positions on a surface of a conductor through which current flows;
   optimizing, based on a predetermined optimization algorithm, current that generates magnetic fields detected at the plurality of detection positions, respectively;
   calculating a plurality of magnetic fields generated at the plurality of detection positions by the optimized current;
   determining whether the acquired plurality of magnetic fields matches the calculated plurality of magnetic fields; and
   outputting a current signal indicating the optimized current, when it is determined that the acquired plurality of magnetic fields matches the calculated plurality of magnetic fields.

9. A current distribution estimation system comprising:

a magnetic field sensor device that detects a plurality of magnetic fields at a plurality of detection positions on a surface of a conductor through which current flows, and that outputs magnetic field signals respectively indicating the detected plurality of magnetic fields; and
a current distribution estimation device that estimates a current distribution that generates magnetic fields corresponding to the magnetic field signals,
the current distribution estimation device comprising:

an acquisition unit that acquires the magnetic field signals;
an optimization unit that optimizes, based on a predetermined optimization algorithm, current that generates magnetic fields detected at the plurality of detection positions, respectively;
a calculation unit that calculates a plurality of magnetic fields generated at the plurality of detection positions by current optimized by the optimization unit;
a determination unit that determines whether the plurality of magnetic fields acquired by the acquisition unit matches the plurality of magnetic fields calculated by the calculation unit; and
an output unit that outputs a current signal indicating the current optimized by the optimization unit, when the determination unit determines that the plurality of magnetic fields acquired by the acquisition unit matches the plurality of magnetic fields calculated by the calculation unit.

Fig. 1 (a)

(b)

# Fig. 2

X-direction

103

Optical path unit

140

142 — Second beam splitter

CCW2
CW2

CW1 CCW1
CCW1 CW1

143 — First beam splitter

141

144

146 148 145
147
148

151 153
152 14
151

145

101

110 Light-emitting unit 113

111 112

Light-emitting element — Isolator — Polarizer

130

120

150 — Beam splitter

$L_P$
$L_S$

160 — Magnetic field signal generating circuit

Ed1

Fig. 3

# Fig. 4

Content estimation device

11 — Communication unit

12 — Storage unit

13 — Input unit

14 — Display unit

Processing unit — 20

Instruction unit — 21

Acquisition unit — 22

Calculation unit — 23

Determination unit — 24

Genetic algorithm execution unit — 25

Output unit — 26

1

# Fig. 5

Start

S101 — Output an n-th detection instruction

S102 — Acquire the detected magnetic field

S103 — Has a magnetic field been detected at all the detection positions ? — NO

YES

S104 — Determine initial values of n-th currents

S105 — Calculate n-th magnetic fields

S106 — Calculate an error

S107 — Is the error less than or equal to a determination threshold ? — NO

YES

S109 — Determine the n-th currents     S108 — Execute a genetic algorithm

S110 — Have currents been determined for all the sampling times ? — NO

YES

S111 — Output a current signal

End

# Fig. 6

```
                    ┌─────────────┐
                    │    Start    │
                    └─────────────┘
                           │
S201 ┐  ┌──────────────────▼──────────────────┐
     └──│   Calculate the degree of           │
        │   fitness of the currents           │
        └──────────────────┬──────────────────┘
                           │
S202 ┐  ┌──────────────────▼──────────────────┐
     └──│ Execute a selection and new individual│
        │        replenishment process         │
        └──────────────────┬──────────────────┘
                           │
S203 ┐  ┌──────────────────▼──────────────────┐
     └──│    Execute a crossover process      │
        └──────────────────┬──────────────────┘
                           │
S204 ┐  ┌──────────────────▼──────────────────┐
     └──│    Execute a mutation process       │
        └──────────────────┬──────────────────┘
                           │
                    ┌──────▼──────┐
                    │    End      │
                    └─────────────┘
```

Fig. 7

(a)

D — W101

Current

Time

(b)

Magnetic field

W202

W201

Width direction of conductor

(c)

Current

Width direction of conductor

# Fig. 8

Content estimation device                                    30      2

Processing unit

| Instruction unit | 21 |

| Acquisition unit | 22 |

| Calculation unit | 23 |

| Determination unit | 24 |

| Gradient descent process execution unit | 35 |

| Output unit | 26 |

11  Communication unit

12  Storage unit

13  Input unit

14  Display unit

# Fig. 9

```
                    ┌─────────┐
                    │  Start  │
                    └────┬────┘
                         │◄──────────────────────────┐
S301 ─┐   ┌──────────────▼──────────────┐            │
      └──▶│      Output an n-th          │            │
          │   detection instruction      │            │
          └──────────────┬──────────────┘            │
S302 ─┐   ┌──────────────▼──────────────┐            │
      └──▶│     Acquire the detected     │            │
          │       magnetic field         │            │
          └──────────────┬──────────────┘            │
S303 ─┐         ╱────────▼────────╲                  │
      └──▶   ╱    Has a magnetic    ╲    NO           │
           ◄ field been detected at all ►─────────────┘
            ╲  the detection positions ╱
             ╲         ?         ╱
              ╲───────┬─────────╱
                   YES│◄───────────────────────────────────┐
S304 ─┐   ┌──────────▼──────────────┐                       │
      └──▶│     Determine initial    │                      │
          │   values of n-th currents│                      │
          └──────────┬──────────────┘                       │
S305 ─┐   ┌──────────▼──────────────┐◄──────────────┐       │
      └──▶│      Calculate n-th      │               │       │
          │     magnetic fields      │               │       │
          └──────────┬──────────────┘               │       │
S306 ─┐   ┌──────────▼──────────────┐               │       │
      └──▶│     Calculate an error   │               │       │
          └──────────┬──────────────┘               │       │
S307 ─┐         ╱────▼────╲                          │       │
      └──▶   ╱   Is the error  ╲    NO               │       │
           ◄ less than or equal to a ►───────┐       │       │
            ╲ determination threshold ╱       │       │       │
             ╲         ?         ╱            │       │       │
              ╲───────┬─────────╱             ▼       │       │
                   YES│            S308 ─┐ ┌───────────┴───┐   │
S309 ─┐   ┌──────────▼──────────┐      └─▶│ Execute a gradient│ │
      └──▶│Determine the n-th currents│    │  descent process │ │
          └──────────┬──────────┘         └──────────────────┘ │
S310 ─┐         ╱────▼────╲                                     │
      └──▶   ╱  Have currents  ╲    NO                          │
           ◄ been determined for all the ►─────────────────────┘
            ╲    sampling times    ╱
             ╲        ?        ╱
              ╲──────┬────────╱
                  YES│
S311 ─┐   ┌─────────▼──────────┐
      └──▶│Output a current signal│
          └─────────┬──────────┘
                    │
               ┌────▼────┐
               │   End   │
               └─────────┘
```

# Fig. 10

EP 4 787 001 A1

## Fig. 11

(a)

Current

W401

Width direction of conductor

(c)

Current

W403

Width direction of conductor

(b)

Magnetic field

W402

Width direction of conductor

(d)

Magnetic field

W404

Width direction of conductor

EP 4 787 001 A1

Fig. 12

Fig. 13

(a)

W601

Current

Time

(b)

W602

Current

Time

(c)

E

Width direction of conductor

Time

Current

(d)

E

Time

Width direction of conductor

Current

# Fig. 14

```
                    ( Start )
                        │
                        ▼
S401 ─┐         ┌──────────────────┐
      │         │ Output an n-th   │
      │         │ detection        │◄────────────┐
      │         │ instruction      │             │
      │         └──────────────────┘             │
      │                 │                         │
S402 ─┐         ┌──────────────────┐             │
      │         │ Acquire the      │             │
      │         │ detected         │             │
      │         │ magnetic field   │             │
      │         └──────────────────┘             │
      │                 │                         │
S403 ─┐         ◄───────────────────►            │
      │        ╱  Has a magnetic     ╲    NO      │
      │       ╱ field been detected   ╲──────────┘
      │       ╲  at all the detection ╱
      │        ╲  positions ?        ╱
      │         ◄───────────────────►
      │            │ YES ◄──────────────────────────────────┐
S404 ─┐         ┌──────────────────┐                        │
      │         │ Determine        │                        │
      │         │ initial values   │                        │
      │         │ of n-th currents │                        │
      │         └──────────────────┘                        │
      │                 │  ◄──────────────────────────┐     │
S405 ─┐         ┌──────────────────┐                  │     │
      │         │ Calculate n-th   │                  │     │
      │         │ magnetic fields  │                  │     │
      │         └──────────────────┘                  │     │
      │                 │                              │     │
S406 ─┐         ◄───────────────────►                 │     │
      │        ╱    Has the          ╲                │     │
      │       ╱  gradient descent     ╲  NO           │     │
      │       ╲  process been executed ╱──────┐       │     │
      │        ╲  a predetermined      ╱       │       │     │
      │        ◄ number of times ? ►            ▼      │     │
      │            │ YES                  ┌──────────┐ │     │
S408 ─┐     ┌──────────────────┐   S407 ─│ Execute a│ │     │
      │     │ Determine the    │         │ gradient │─┘     │
      │     │ n-th currents    │         │ descent  │       │
      │     └──────────────────┘         │ process  │       │
      │                 │                └──────────┘       │
S409 ─┐         ◄───────────────────►                       │
      │        ╱  Have currents       ╲   NO                │
      │       ╱ been determined for    ╲────────────────────┘
      │       ╲  all the sampling      ╱
      │        ╲  times ?             ╱
      │         ◄───────────────────►
      │            │ YES
S410 ─┐     ┌──────────────────┐
      │     │ Output a current │
      │     │ signal           │
      │     └──────────────────┘
      │                 │
                    ( End )
```

Fig. 15

## INTERNATIONAL SEARCH REPORT

| International application No. |
| --- |
| **PCT/JP2024/029870** |

| A. | CLASSIFICATION OF SUBJECT MATTER |
| --- | --- |

*G01R 33/10*(2006.01)i; *G01R 15/20*(2006.01)i; *G01R 19/00*(2006.01)i; *G01R 33/02*(2006.01)i
FI:  G01R33/10; G01R19/00 Z; G01R15/20 C; G01R33/02 K

According to International Patent Classification (IPC) or to both national classification and IPC

| B. | FIELDS SEARCHED |
| --- | --- |

Minimum documentation searched (classification system followed by classification symbols)

G01R33/10; G01R15/20; G01R19/00; G01R33/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 9-152363 A (MITSUBISHI ELECTRIC CORPORATION) 10 June 1997 (1997-06-10) paragraphs [0024]-[0027], [0030], [0033], [0037], fig. 6 | 1-9 |
| Y | JP 2016-500812 A (MAGCAM NV) 14 January 2016 (2016-01-14) paragraph [0049] | 1-9 |
| Y | JP 2015-200522 A (TOYOTA JIDOSHA KABUSHIKI KAISHA) 12 November 2015 (2015-11-12) paragraphs [0041]-[0044] | 4-6 |
| Y | US 2005/0046532 A1 (DODD, Stephen J.) 03 March 2005 (2005-03-03) paragraphs [0033], [0037], [0043] | 4-6 |
| A | JP 3-216572 A (ALPS ELECTRIC CO., LTD.) 24 September 1991 (1991-09-24) entire text, all drawings | 1-9 |
| A | JP 2020-101451 A (HIOKI ELECTRIC WORKS) 02 July 2020 (2020-07-02) entire text, all drawings | 1-9 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **07 October 2024** | **22 October 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/029870**

| Patent document cited in search report | | | Publication date (day/month/year) | Patent family member(s) | | | Publication date (day/month/year) |
|---|---|---|---|---|---|---|---|
| JP | 9-152363 | A | 10 June 1997 | (Family: none) | | | |
| JP | 2016-500812 | A | 14 January 2016 | US paragraphs [0071]-[0075] WO EP CN | 2015/0276895 2014/060224 2720059 104884966 | A1 A1 A1 A | |
| JP | 2015-200522 | A | 12 November 2015 | (Family: none) | | | |
| US | 2005/0046532 | A1 | 03 March 2005 | (Family: none) | | | |
| JP | 3-216572 | A | 24 September 1991 | (Family: none) | | | |
| JP | 2020-101451 | A | 02 July 2020 | (Family: none) | | | |

Form PCT/ISA/210 (patent family annex) (July 2022)

**EP 4 787 001 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7222480 B